# EUROPEAN PATENT SPECIFICATION

(11) **EP 3 128 618 B1**
(45) Date of publication and mention of the grant of the patent: **24.07.2019**
(21) Application number: 15786084.2
(22) Date of filing: 28.04.2015
(51) Int. Cl.: H01L 39/02, H01L 39/24

(54) **SUPERCONDUCTING WIRE ROD CONNECTION STRUCTURE AND CONNECTION METHOD, AND SUPERCONDUCTING WIRE ROD**
SUPRALEITENDE WALZDRAHTVERBINDUNGSSTRUKTUR UND VERBINDUNGSVERFAHREN SOWIE SUPRALEITENDER WALZDRAHT
STRUCTURE DE CONNEXION ET PROCÉDÉ DE CONNEXION DE TIGE DE FIL SUPRACONDUCTEUR, ET TIGE DE FIL SUPRACONDUCTEUR

(30) Priority: 01.05.2014 JP 2014094748; 14.05.2014 JP 2014100322
(43) Date of publication of application: 08.02.2017
(60) Divisional application: 19175232.8
(73) Proprietor: Furukawa Electric Co., Ltd., Chiyoda-ku Tokyo 100-8322 (JP)
(72) Inventor: AMANO, Toshiaki, Tokyo 100-8322 (JP); LIU, Jin, Tokyo 100-8322 (JP); YASUNAGA, Shinya, Tokyo 100-8322 (JP); MATSUI, Norio, Tokyo 100-8322 (JP); HATAKEYAMA, Hideyuki, Tokyo 100-8322 (JP); YAMAMOTO, Kiyoshi, Tokyo 100-8322 (JP); YAGI, Masashi, Tokyo 100-8322 (JP)
(74) Representative: Horn Kleimann Waitzhofer Patentanwälte PartG mbB
(86) International application number: PCT/JP2015/062768
(87) International publication number: WO 2015/166936

(56) References cited:
- WO-A1-2013/165001
- WO-A1-2014/058092
- WO-A1-2014/058092
- JP-A- 2012 113 864

## Description

### Technical Field

The present invention relates to a superconducting wire rod connection structure and connection method, and superconducting wire rod.

### Background Art

Lately, oxide superconductors such as YBCO-type (yttrium-type), Bi-type (bismuth-type) are gathering attention as oxide superconductors with a critical temperature (Tc) higher than the liquid nitrogen temperature (about 77K).

Such well-known high temperature oxide superconductor wire rods include those with a superconducting conductor layer formed by depositing an oxide superconductor film on a substrate such as a flexible long metal, or depositing an oxide superconductor film on a single crystal substrate. An intermediate layer is provided as necessary between the substrate and the superconducting conductor layer.

As a connection method of the superconducting wire rod, Patent Literature 1 describes placing the superconducting conductor layers of the superconducting wire rod in contact with each other in a sealed container, heating the above, ejecting superconducting fine powder with the same type as an inert gas from a nozzle toward the contacting unit, and heating the fine powder to connect the superconducting conductor layers.

Patent Literature 2 describes a method of closely attaching the superconducting conductor layers of the superconducting wire rod and depositing a superconducting film contacting the ends of both superconducting conductor layers in order to connect the superconducting conductor layers.

Patent Literature 3 describes a connection method of removing the superconducting conductor layer of a connection end and connecting the metal substrates by butt welding and forming a superconducting film in the connection ends in which the superconducting conductor layer is removed.

Patent Literature 4 describes a connection method of exposing the oxide superconductor included in a sheath of the two superconducting wire rods to be connected, applying MOD liquid based on MOD method (Metal Organic Deposition method) on the exposed surface and baking the exposed surfaces attached to each other to connect two superconducting wire rods through the superconducting film formed from the MOD liquid.

Patent Literature 5 describes a connection method of exposing a superconducting conductor layer of 2 superconducting wire rods in which a superconducting conducting layer is formed through a buffer layer on an upper surface of a substrate, and heating the superconducting conductor layers to a melting point with the superconducting conductor layers closely attached to each other to melt and spread the superconducting conductor layers to connect the two superconducting wire rods.

WO 2013/165001 A1 discloses a superconducting wire material connection structure according to the preamble of claim 1. Another method for joining second generation ReBCO high temperature superconductors is disclosed in WO 2014/058092 A1.

### Prior Art Document

### Patent Document

Patent Document 1: Japanese Patent No. 2688923
Patent Document 2: Japanese Patent Application Laid-Open Publication No. 2005-063695
Patent Document 3: Japanese Patent No. 3836299
Patent Document 4: Japanese Patent Application Laid-Open Publication No. 2009-016253
Patent Document 5: Japanese Patent No. 5214744

### Disclosure of the Invention

### Problems to be Solved by the Invention

However, according to the connection method of Patent Literature 1, the thickness of the heated portion and the contact area with the thin film needs to be made large so that the superconducting critical current density (Jc) of the superconducting heated body does not become small. If the superconducting critical current density is not large enough, large electric resistance occurs in the heated portion when current exceeding the superconducting critical current density flows.

According to the connection method of Patent Literature 2, since the area of the end of the superconducting conductor layer is small, there is a large difference in the quality of connection, and the critical current tends to be small and the connection strength tends to be weak.

According to the connection method of Patent Literature 3, the connection strength is sufficient but when the metal substrate is melted, the metal element diffuses due to high temperature and the superconducting layer near the melted portion is damaged. Therefore, the superconducting critical current density cannot be made sufficiently large between the superconducting conductor layer and the formed superconducting film.

According to the connection method of Patent Literature 4 and Patent Literature 5, heating is performed when the superconducting conductor layers are joined. When the superconducting conductor layer is an oxide superconducting conductor layer such as YBa₂Cu₃O₇₋ₓ, the oxygen may come out of the superconducting conductor layer after joining and the superconductivity may be greatly damaged.

Therefore, it is necessary to perform oxygen annealing to oxidize the connection portion of the superconducting wire rod under an oxygen atmosphere of about 500°C.

However, according to the above-described connection structure of the superconducting wire rod, in most cases, the superconducting conductor layer is placed between the base material, and the base material is formed from metal which hardly has oxygen permeability.

Therefore, the base material becomes a barrier layer and oxygen hardly reaches the inner side portion between the base materials. As a result, sufficient oxygen annealing cannot be performed, or a large amount of time is needed for oxygen annealing.

The purpose of the present invention is to provide a superconducting wire rod connection structure and connection method, and superconducting wire rod with high connection strength and large superconducting critical current density.

Another purpose of the present invention is to provide a superconducting wire rod connection structure and connection method, and superconducting wire rod in which oxygen annealing can be performed efficiently. Means for Solving the Problem

In order to solve the above-mentioned problems, the invention provides a superconducting wire rod connection structure according to claim 1 and a corresponding connection method according to claim 14. Further details are laid out in the dependent claims.

### Advantageous Effect of the Invention

According to the above-described configuration of the present invention, it is possible to provide a superconducting wire rod connection structure and connection method, and superconducting wire rod with high connection strength and a large superconducting critical current density.

According to the above-described configuration of the present invention, it is possible to effectively perform oxygen annealing.

### Brief Description of the Drawings

FIG. 1 is a perspective view of a superconducting wire rod.
FIG. 2 is a cross-sectional view showing a connection configuration of a superconducting wire rod according to the first example.
FIG. 3A is a cross-sectional view showing a step in a connection method of the superconducting wire rod.
FIG. 3B is a cross-sectional view showing a step in a connection method of the superconducting wire rod following the step shown in FIG. 3A.
FIG. 3C is a cross-sectional view showing a step in a connection method of the superconducting wire rod following the step shown in FIG. 3B.
FIG. 3D is a cross-sectional view showing a step in a connection method of the superconducting wire rod following the step shown in FIG. 3C.
FIG. 3E is a cross-sectional view showing a step in a connection method of the superconducting wire rod following the step shown in FIG. 3D.
FIG. 3F is a cross-sectional view showing a step in a connection method of the superconducting wire rod following the step shown in FIG. 3E.
FIG. 4A is a cross-sectional view showing a step of a connection method when a connection superconducting film is formed in first and second superconducting wire rods and a connection wire rod.
FIG. 4B is a cross-sectional view showing a step of a connection method of the superconducting wire rod following the step shown in FIG. 4A.
FIG. 4C is a cross-sectional view showing a step of a connection method of the superconducting wire rod following the step shown in FIG. 4B.
FIG. 5 is a cross-sectional view showing a connection structure of a superconducting wire rod in which the connection wire rod includes a stabilizing layer.
FIG. 6A is a cross-sectional view showing a step in a connecting direction of a superconducting wire using a connection wire rod not including a base material.
FIG. 6B is a cross-sectional view showing a step in a connection method of the superconducting wire rod following the step shown in FIG. 6A.
FIG. 7 is a cross-sectional view showing a connection configuration of a superconducting wire rod according to the second example.
FIG. 8 is a cross-sectional view showing a connection configuration of a superconducting wire rod according to the third example.
FIG. 9A is a cross-sectional view showing a step in a connection method of the superconducting wire rod.
FIG. 9B is a cross-sectional view showing a step in a connection method of the superconducting wire rod following the step shown in FIG. 9A.
FIG. 9C is a cross-sectional view showing a step in a connection method of the superconducting wire rod following the step shown in FIG. 9B.
FIG. 9D is a cross-sectional view showing a step in a connection method of the superconducting wire rod following the step shown in FIG. 9C.
FIG. 9E is a cross-sectional view showing a step in a connection method of the superconducting wire rod following the step shown in FIG. 9D.
FIG. 9F is a cross-sectional view showing a step in a connection method of the superconducting wire rod following the step shown in FIG. 9E.
FIG. 10 is a cross-sectional view showing a connection structure of a superconducting wire rod according to the fourth example.
FIG. 11 is a cross-sectional view showing a connection structure of a superconducting wire rod according to the fifth example.
FIG. 12 is a cross-sectional view showing a connection structure of a superconducting wire rod according to the sixth example.
FIG. 13 is a cross-sectional view showing a connection structure of a superconducting wire rod according to the seventh example.
FIG. 14 is a perspective view of another superconducting wire rod.
FIG. 15A is a cross-sectional view of a connection structure of a superconducting wire rod of the eighth example along line V-V shown in FIG. 15B.
FIG. 15B is a planar view showing a connection structure of a superconducting wire rod according to the eighth example.
FIG. 16A is a cross-sectional view showing a step in a connection method of the superconducting wire rod.
FIG. 16B is a cross-sectional view showing a step in a connection method of the superconducting wire rod following the step shown in FIG. 16A.
FIG. 16C is a cross-sectional view showing a step in a connection method of the superconducting wire rod following the step shown in FIG. 16B.
FIG. 16D is a cross-sectional view showing a step in a connection method of the superconducting wire rod following the step shown in FIG. 16C.
FIG. 16E is a cross-sectional view showing a step in a connection method of the superconducting wire rod following the step shown in FIG. 16D.
FIG. 17 is a cross-sectional view showing an example of an opening formed by a laser process.
FIG. 18A is a side view showing an example of applying a reinforcing member to the superconducting wire rod connection structure
FIG. 18B is a diagram viewing another end of the reinforcing member from a second superconducting wire rod side.
FIG. 19 is a cross-sectional diagram showing an example of forming an opening in both the first and second superconducting wire rod.
FIG. 20 is a cross-sectional view showing a connection structure of a superconducting wire rod of the ninth example.
FIG. 21A is a cross-sectional view showing a step in a connection method of the superconducting wire rod.
FIG. 21B is a cross-sectional view showing a step in a connection method of the superconducting wire rod following the step shown in FIG. 21A.
FIG. 21C is a cross-sectional view showing a step in a connection method of the superconducting wire rod following the step shown in FIG. 21B.
FIG. 21D is a cross-sectional view showing a step in a connection method of the superconducting wire rod following the step shown in FIG. 21C.
FIG. 21E is a cross-sectional view showing a step in a connection method of the superconducting wire rod following the step shown in FIG. 21D.
FIG. 22 is a cross-sectional view showing a connection structure of a superconducting wire rod according to the tenth example.
FIG. 23 is a cross-sectional view showing a connection structure of a superconducting wire rod according to the embodiment.

Examples and Embodiment for Carrying Out the Invention

### [First Example]

A first example not forming part of the present invention is described with reference to the drawings. The examples described below include various limitations technically preferable to implement the present invention. However, the scope of the present invention is not limited to the examples and embodiments described below and the illustrated examples, but defined by the claims. In the drawings, the same reference numerals are applied to the same or corresponding components, and redundant description is omitted. The drawings are schematic illustrations, and it is necessary to understand that the relation of the size of each element may be different from the actual size. The relation and the ratio of the size being different can be said for the differences among the drawings.

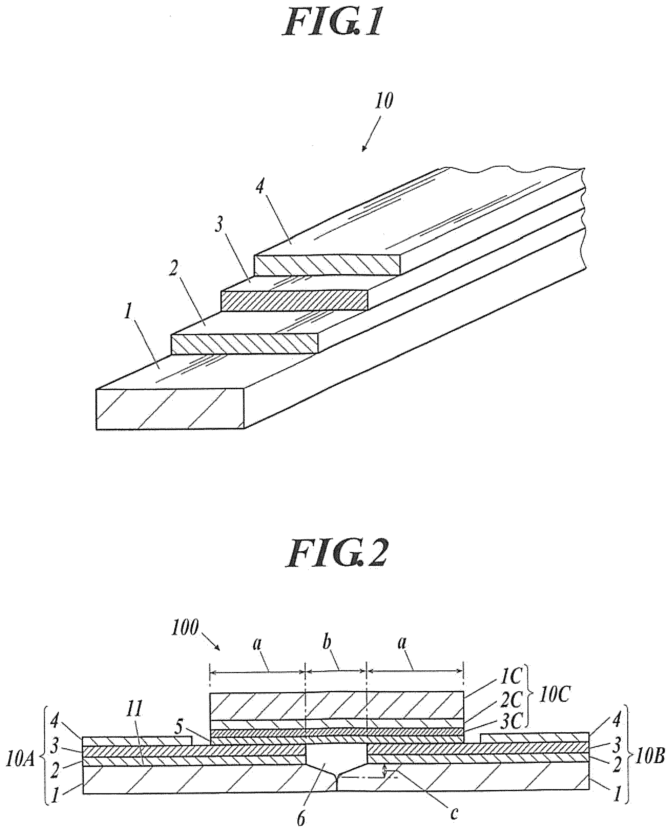

FIG. 1 is a perspective view of the superconducting wire rod according to a first example.

As shown in FIG. 1, the superconducting wire rod 10 is formed by layering in order an intermediate layer 2, an oxide superconducting conductor layer 3 and a stabilizing layer 4 on one main surface (hereinafter referred to as film forming surface 11) of a superconducting film forming base material 1 (hereinafter referred to as base material 1) in a thickness direction. That is, the superconducting wire rod 10 includes a layered configuration including a base material 1, an intermediate layer 2, an oxide superconducting conductor layer 3 (hereinafter referred to as superconducting conductor layer 3) and stabilizing layer 4.

A tape-shaped low magnetic metallic substrate and ceramics substrate are used as the base material 1. The following material is used for the metallic substrate, for example, metal such as Co, Cu, Cr, Ni, Ti, Mo, Nb, Ta, W, Mn, Fe, Ag, etc., or alloys thereof which have excellent strength and heat resistance. Specifically, from the viewpoint of excellent corrosion resistance and heat resistance, it is preferable to use an Ni based alloy such as Hastelloy (registered trademark) or Inconel (registered trademark), etc. or an Fe based alloy such as stainless steel, etc.

Moreover, various ceramics can be provided on the various metallic material, Examples of material for the ceramics substrate include, MgO, SrTiO₃, yttrium stabilized zirconia, etc. Other material such as sapphire can also be used as the base material.

Preferably, the film forming surface 11 is substantially a flat and smooth surface, the surface roughness of the film forming surface 11 is 10 nm or less.

The surface roughness is the arithmetic average roughness Ra in "amplitude average parameter in a height direction" in the surface roughness parameter determined in JISB-0601-2001.

The intermediate layer 2 is a layer to enable, for example, dual axis orientation in the superconducting conductor layer 3. For example, physical characteristic values such as a thermal expansion coefficient, grating constant, etc. of the intermediate layer 2 show intermediate values between the base material 1 and the superconducting conductor layer 3 composing the superconductor.

The intermediate layer 2 can be a single layer configuration or a multi-layer configuration. When the intermediate layer 2 is a multi-layer configuration, the number of layers and the type of layer is not limited. The configuration may include the following layered in order, a bed layer including amorphous material such as Gd₂Zr₂O_{7-δ} (δ is oxygen non-stoichiometric amount) or Al₂O₃, or Y₂O₃, etc., a forced orientation layer including crystalline material such as MgO, etc., and formed with an IBAD (Ion Beam Assisted Deposition) method, and a LMO layer including LaMnO_{3+δ} (δ is oxygen non-stoichiometric amount). Alternatively, a gap layer including CeO₂ can be provided on the LMO layer.

The thickness of each layer is to be the following, the LMO layer is 30 nm, the MgO layer as the forced orientation layer is to be 40 nm, the Y₂O₃ layer as the bed layer is to be 7 nm, and the Al₂O₃ layer is to be 80 nm. These values are all one example.

Preferably, the intermediate layer 2 includes an Al₂O₃ (alumina) layer regardless of whether the configuration is the single-layer configuration or the multi-layer configuration.

The superconducting conductor layer 3 is layered on the surface of the intermediate layer 2. Preferably, an oxide superconducting conductor, specifically, a copper-oxide superconducting conductor is included in the superconducting conductor layer 3. REBa₂Cu₃O_{7-δ} (hereinafter referred to as RE-type conductor) as a high temperature superconducting conductor is preferable as the copper superconducting conductor. The RE in RE-type superconducting conductor can be a single rare earth element or a plurality of rare earth elements such as Y, Nd, Sm, Eu, Gd, Dy, Ho, Er, Tm, Yb, and Lu, and among the above, Y is especially preferable due to the reason that substitution with the Ba site hardly occurs. Moreover, δ is the oxygen non-stoichiometric amount. For example, the oxygen non-stoichiometric amount is 0 or more and 1 or less, and it is more preferable as the value becomes closer to 0 from the viewpoint of the superconducting transfer temperature being high. When high pressure oxygen annealing, etc. is performed using an apparatus such as an autoclave, the oxygen non-stoichiometric amount δ may be less than 0, that is, a negative value.

The stabilizing layer 4 covers the surface of the superconducting conductor layer 3, and preferably, the stabilizing layer 4 covers the base material 1, the intermediate layer 2, and the superconducting conductor layer 3 entirely.

The stabilizing layer 4 can be a single layer configuration or a multi-layer configuration. When the configuration is a multi-layer configuration, the number of layers and the type is not limited, and the configuration can be a silver stabilizing layer including silver and a copper stabilizing layer including copper layered in order.

The present example and all of the following examples and embodiments described below show a superconducting wire rod connection structure 100, 100A ...or 100M and a superconducting wire rod including such superconducting wire rod connection structure 100, 100A ...or 100M. The "superconducting wire rod connection structure 100, 100A ...or 100M" shows a superconducting wire rod including first and second superconducting wire rods 10A, 10B connected by any of the connection structures 100 to 100M.

The superconducting wire rod connection structure 100 of the present example is formed by a later described connection method which connects connection ends of the first and second superconducting wire rods 10A, 10B confronting each other as shown in FIG. 2. The first and second superconducting wire rods 10A, 10B have the same configuration as the superconducting wire rod 10, and the reference numerals which are the same as those in the superconducting wire rod 10 are used for the layers 1 to 4.

In the connection structure 100, the base materials 1, 1 of the connection ends of the first and second superconducting wire rods 10A, 10B are joined by welding, the superconducting conductor layers 3, 3 of the connection ends of the first and second superconducting wire rods 10A, 10B are connected bridged by a connection wire rod 10C including a superconducting conductor layer 3C, and a space 6 as a separating portion is formed by separating the connection end and the connection wire rod 10C between the connection ends of the first and second superconducting wire rods 10A, 10B joined by the joining portion of the base materials 1, 1 and the connection wire rod 10C.

Hereinafter, including the other examples and the "connection wire rod" may be referred to as the "connection superconducting wire rod".

### [Connection Method]

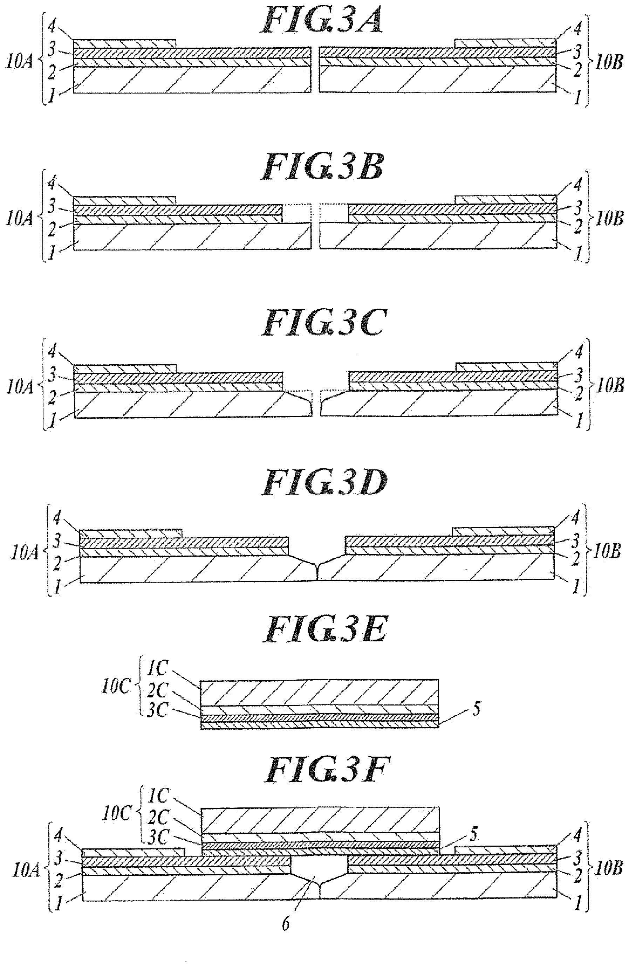

The connection method of the connection structure 100 is described in the order of the steps of the method based on FIG. 3A to FIG. 3F.

First, as shown in FIG. 3A, the stabilizing layers 4, 4 in the connection end sides of the first and second superconducting wire rods 10A, 10B are removed, and the superconducting conductor layers 3, 3 are exposed (exposing step). The removal of the stabilizing layer 4 is performed by mechanical polishing, chemical polishing, or a combination of the above.

For example, when silver or a silver alloy is used as the stabilizing layer 4, and the stabilizing layer 4 is removed chemically, it is preferable to use an aqueous solution composed of hydrogen peroxide and ammonia as a parting agent.

It is preferable that the surface roughness of the superconducting conductor layer 3 exposed by pealing the stabilizing layer 4 is made smaller in order to form a later described connection superconducting film 5 well in a later described wire rod attaching step.

Next, as shown in FIG. 3B, a portion of the connection end side of the superconducting conductor layers 3, 3 exposed by pealing the stabilizing layers 4, 4 of the first and second superconducting wire rods 10A, 10B, and a portion of the connection end side of the intermediate layers 2, 2 are removed to expose the surface of the base materials 1, 1 (first removal step). Such removal is performed by mechanical polishing, chemical polishing, or a combination thereof.

As shown in FIG. 3C, a portion of the connection ends of the base materials 1, 1 exposed by the first removal step is performed within the range equal to the removed range of the superconducting conductor layers 3, 3 and intermediate layers 2, 2. That is, as shown in FIG. 3C, the base materials 1, 1 are partially removed in a shape so that the thickness of the base materials become gradually thin toward the connection end side (second removal step).

The base materials 1, 1 are removed by mechanical polishing, chemical polishing, or a combination thereof.

Next, as shown in FIG. 3D, the base materials 1, 1 of the first and second superconducting wire rods 10A, 10B are joined by welding with the connection ends confronting each other (joining step). With this, the first superconducting wire rod 10A and the second superconducting wire rod 10B are connected through the base materials 1 with a suitable strength.

By linking the base materials 1, 1, a space region in a substantial pentagon is formed in the connection portion of the first and second superconducting wire rods 10A, 10B by the removed portions of the superconducting conductor layers 3, 3 and the intermediate layers 2, 2 removed by the first removal step and the removed portions of the base materials 1, 1 removed by the second removal step.

Next, as shown in FIG. 3E, a connection wire rod 10C is prepared to be bridged on the superconducting conductor layers 3, 3 of the first and second superconducting wire rods 10A, 10B. The connection wire rod 10C is a layered body in which an intermediate layer 2C and a superconducting conductor layer 3C are layered in order on a base material 1C (FIG. 3E illustrates the superconducting conductor layer 3C facing downward). The base material 1C, the intermediate layer 2C, and the superconducting conductor layer 3C of the connection wire rod 10C are each formed from the same material as the base material 1, the intermediate layer 2, and the superconducting conductor layer 3 of the first or second superconducting wire rods 10A, 10B.

The connection wire rod 10C does not include the stabilizing layer 4 and the entire surface of the superconducting conductor layer 3C is exposed throughout the entire length. Preferably, the surface roughness of the superconducting conductor 3C of the connection wire rod 10C is sufficiently small. The connection wire rod 10C can be obtained by removing the stabilizing layer 4 from the superconducting wire rod which is the same as the first or second superconducting wire rod 10A, 10B.

The connection superconducting film 5 is formed between the superconducting conductor layer 3C of the connection superconducting wire rod 10C, and the superconducting conductor layers 3, 3 of the first and second superconducting wire rods 10A, 10B using the MOD method (Metal Organic Deposition method).

Therefore, an MOD liquid to form the connection superconducting film 5 based on the MOD method is applied to the surface of the superconducting conductor layer 3C of the connection wire rod 10C.

For example, an acetylacetonate type MOD liquid including RE (rare earth elements such as Y (yttrium), Gd (gadolinium), Sm (samarium), Ho (holmium)), Ba, and Cu with a ratio of about 1:2:3 is used as the MOD liquid.

The MOD liquid is applied on at least the either one of the superconducting conductor layer 3C of the connection wire rod 10C or the superconducting conductor layers 3, 3 of the first and second superconducting wire rods 10A, 10B, and alternatively, the MOD liquid can be applied on both of the above.

Next, as shown in FIG. 3F, the connection wire rod 10C is positioned on the exposed surface of the superconducting conductor layers 3, 3 with the superconducting conductor layer 3C of the connection wire rod 10C facing the superconducting conductor layers 3, 3 of the first and second superconducting wire rods 10A, 10B. The superconducting conductor layers 3, 3 of the connection ends of the first and second superconducting wire rods 10A, 10B are connected by the connection wire rod 10C in a bridging state (wire rod attaching step).

Next, a preliminary baking step to remove the organic component including the MOD liquid is applied to the connection wire rod 10C and a main baking step to allow epitaxial growth on an interface between the superconducting conductor layers 3, 3 of the first and second superconducting wire rods 10A, 10B and the superconducting conductor layer 3C of the connection wire rod 10C in order to form the connection superconducting film 5 are performed under a predetermined pressuring environment (film forming step).

Next, an oxygen annealing step is performed to dope oxygen on the superconducting conductor layers 3, 3 of the first and second superconducting wire rods 10A, 10B, the superconducting conductor layer 3C of the connection wire rod 10C, and the newly formed connection superconducting film 5. The oxygen annealing step is performed with the connection ends of the first and second superconducting wire rods 10A, 10B and the connection wire rod 10C stored in an oxygen atmosphere under a predetermined heating environment.

Alternatively, after the oxygen annealing, a stabilizing layer forming step can be added in which a silver stabilizing layer is formed by vapor deposition of silver on the surface of the connection portion, or by applying silver paste then baking, and then a copper stabilizing layer is formed on the silver stabilizing layer by an electric field coating method. Here, the stabilizing layer can be formed so as to fill the space 6.

As described above, in the wire rod attaching step and the film forming step, the connection superconducting films 5, 5 can be formed on the exposed superconducting conductor layers 3, 3 on the first and second superconducting wire rods 10A, 10B.

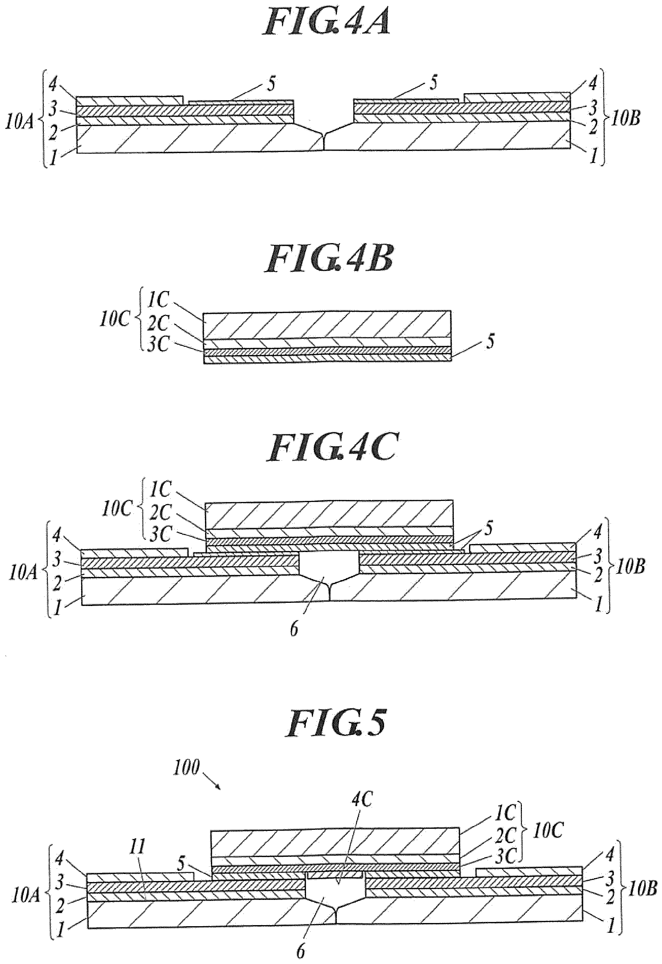

In this case, as shown in FIG. 4A, the MOD liquid is also applied to the exposed surface of the superconducting conductor layers 3, 3 of the first and second superconducting wire rods 10A, 10B with the base materials 1, 1 joined to each other.

Then, as shown in FIG. 4B, the connection wire rod 10C is positioned on the exposed surface of the superconducting conductor layers 3, 3 with the superconducting conductor layer 3C of the connection wire rod 10C on which MOD liquid is applied facing the superconducting conductor layers 3, 3 of the first and second superconducting wire rods 10A, 10B.

Then, as shown in FIG. 4C, after the preliminary baking step and the main baking step is performed, the connection superconducting film 5 is formed on the first and second superconducting wire rod 10A, 10B side and the superconducting conductor layer 3C side.

Then, the oxygen annealing step, etc. is performed.

By forming the connection structure 100 of the superconducting wire rod as described above, excellent superconducting connection can be realized for the connection of the first and second superconducting wire rods 10A, 10B through the connection wire rod 10C.

### [Example 1]

A more specific embodiment of the above-described superconducting wire rod connection structure 100 is described. The various setting values of the examples and embodiments described below are all merely examples and do not limit the contents of the present invention.

As shown in FIG. 2, a length a in which each of the superconducting conductor layers 3, 3 of the first and second super conducting wire rods 10A, 10B overlap with the superconducting conductor layer 3C of the connection wire rod 10C is to be about 15 mm, a length b of the space 6 is to be about 4 to 5 mm, and a length of the connection wire rod 10C is about 34 to 35 mm.

The "length" shows the length of the first and second superconducting wire rods 10A, 10B in the longitudinal direction. The same can be said for the "length" described hereinafter.

A depth c of the space 6 with the base materials 1, 1 removed is to be about 10 µm, a thickness of the base materials 1, 1 is to be about 50 µm, a thickness of the intermediate layers 2, 2 is to be about 200 nm, a thickness of the superconducting conductor layers 3, 3 is to be about 1 µm, a thickness of the connection superconducting film 5 is to be about 100 nm to 1 µm.

The surface roughness (center line average roughness Ra) of the superconducting conductor layers 3, 3 of the first and second superconducting wire rods 10A, 10B after removing the stabilizing layers 4, 4 and the surface roughness of the superconducting conductor layer 3C of the connection wire rod 10C before forming the connection superconducting film 5 in the connection method shown in FIG. 3A to FIG 3F are all preferably 50 nm or less, and more preferably 10 nm or less.

According to the preliminary baking step in the wire rod attaching step, thermal processing in a temperature range of 400°C or higher and 500° or lower is performed on the connection ends of the first and second superconducting wire rods 10A, 10B and the connection wire rod 10C.

Moreover, according to the main baking step, thermal processing in a temperature range of 750°C or higher and 830° or lower while applying pressure within the range of 10 to 200 MPa is performed on the connection ends of the first and second superconducting wire rods 10A, 10B and the connection wire rod 10C.

According to the oxygen annealing step, the connection ends of the first and second superconducting wire rods 10A, 10B and the connection wire rod 10C are treated in an oxygen atmosphere with a temperature range of 350°C or higher and 500°C or lower and the oxygen doping is performed under the above condition.

An excellent superconducting wire rod connection structure 100 is formed under the above conditions.

### [Technical Features of the Example]

According to the superconducting wire rod connection structure 100, the superconducting conductor layers 3, 3 of the first and second superconducting wire rods 10A, 10B are connected by the superconducting conductor layer 3C of the connection wire rod 10C bridging the above. Therefore, the superconducting critical current density can be made sufficiently large, and the superconducting state can be maintained well even in a large current.

The base materials 1, 1 of the first and second superconducting wire rods 10A, 10B are joined by welding, and the connection strength in the connection structure can be maintained highly.

The present example includes a space 6 between the joining portion of the base materials of the first superconducting wire rod 10A and the second superconducting wire rod 10B and the connection wire rod 10C. Therefore, the joining portion joining the base materials 1, 1 can be separated from the superconducting conductor layers 3, 3 of the superconducting wire rods 10A, 10B. When the superconducting conductor layers 3, 3 of the first and second superconducting wire rods 10A, 10B are heated by welding, there is a shift in the crystal orientation, and the crystal configuration worsens between the connection superconducting film 5. However, when there is a space 6, the influence of metallic element diffusion when the base materials 1, 1 are welded and the influence of heat in welding can be reduced. With this, the damage of the superconducting conductor layers 3, 3 of the first and second superconducting wire rods 10A, 10B can be suppressed, and the connection superconducting film 5 can be formed well. Therefore, the critical current density can be large enough between the superconducting conductor layers 3, 3 of the first and second superconducting wire rods 10A, 10B.

By providing the space 6, in the oxygen annealing step, the portion in the connection superconducting film 5 facing the space 6 and the portion near the connection ends of the first and second superconducting wire rods 10A, 10B can be provided with oxygen sufficiently, and the oxygen doping can be performed well. With this, sufficient critical current attributes can be obtained by a short annealing process.

Similarly, oxygen can be sufficiently supplied to a portion near the connection end in the superconducting conductor layers 3, 3 of the first and second superconducting wire rods 10A, 10B, and the oxygen doping can be performed well.

The space 6 can be formed by removing only the superconducting conductor layers 3, 3 of the first and second superconducting wire rods 10A, 10B or only the superconducting conductor layers 3, 3 and the intermediate layers 2, 2. In this case also, the damage of the superconducting conductor layers 3, 3 can be reduced, the connection superconducting film 5 can be formed well, the critical current density can be enhanced and effects of good oxygen doping can be achieved. Further, as shown in FIG. 2, by removing a portion of the connection end of the base materials 1, 1, the effects can be enhanced even more.

The connection superconducting film 5 is formed between the superconducting conductor layers 3, 3 of the first and second superconducting wire rods 10A, 10B and the superconducting conductor layer 3C of the connection wire rod 10C. Therefore, the critical current density between the superconducting conductor layers 3, 3 and the superconducting conductor layer 3C can be made sufficiently large, and the good superconducting state can be maintained.

The connection structure 100 shown in FIG. 2 shows a connection wire rod 10C not including a stabilizing layer, but the present invention is not limited to the above. That is, as shown in FIG. 5, the structure can include a stabilizing layer 4C in a portion facing the space 6 in the connection wire rod 10C. The stabilizing layer 4C includes the same material and the same structure as the above-described stabilizing layer 4. For example, the stabilizing layer 4C can be formed in the connection wire rod 10C with the same layer structure as the first or second superconducting wire rods 10A, 10B by removing the unnecessary stabilizing layer by etching with the exception of the portion facing the space 6.

According to the connection method using the connection wire rod 10C including the stabilizing layer 4C, in the wire rod attaching step, the MOD liquid is applied to both sides of the superconducting conductor layer 3C of the connection wire rod 10C with the exception of the stabilizing layer 4C, and the connection superconducting film 5 is formed between the superconducting conductor layer 3C of the connection wire rod 10C and the superconducting conductor layers 3, 3 of the connection ends of the first and second superconducting wire rods 10A, 10B in the film forming step.

The steps other than the above are the same as the connection method shown in the above-described FIG. 3A to FIG. 3F.

As described above, according to the structure including the stabilizing layer 4 in the portion facing the space 6 in the connection wire rod 10C, the superconducting conductor layer 3C of the connection wire rod 10C coming into contact with the base materials 1, 1 of the first and second superconducting wire rods 10A, 10B can be reduced, and the diffusion of impurities to the superconducting conductor layer 3C can be suppressed.

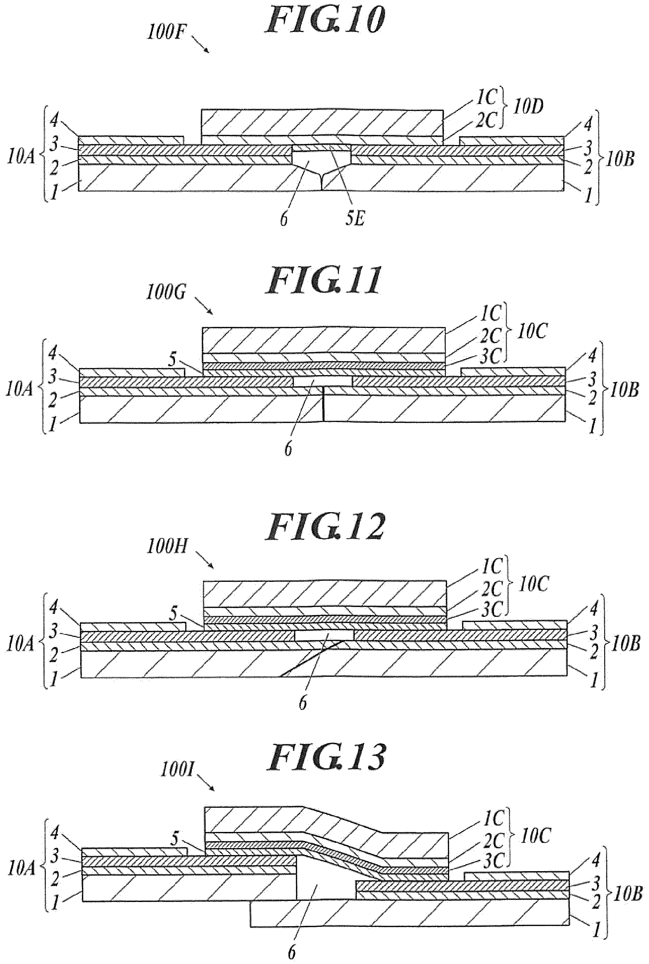

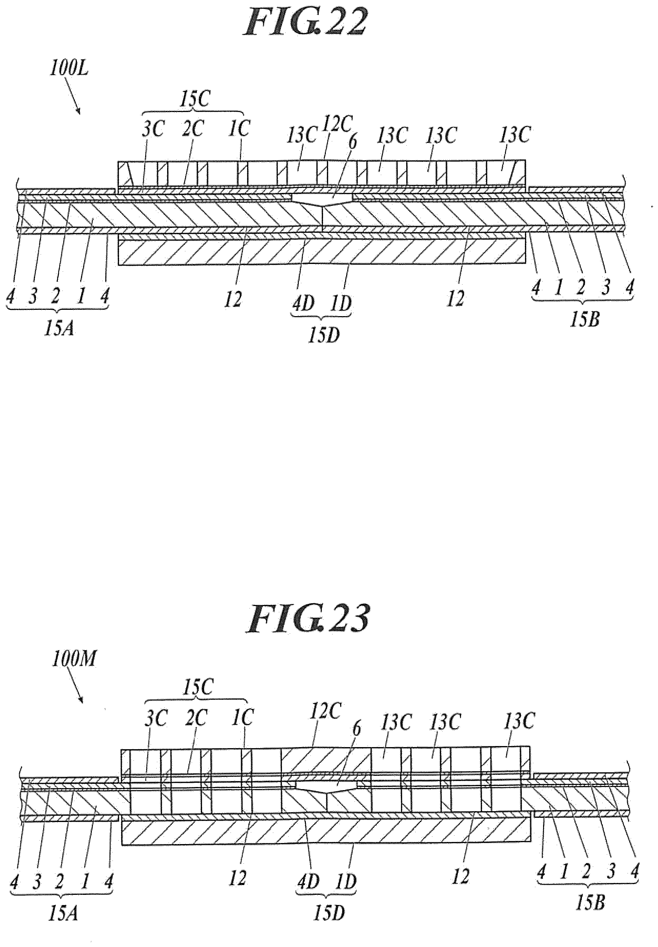

The stabilizing layer 4C provided in the portion facing the space 6 in the connection wire rod 10C can also be provided in other connection structures including the space 6, for example, 100G (FIG. 11), 100H (FIG. 12), 1001 (FIG. 13), 100L (FIG. 22), 100M (FIG. 23).

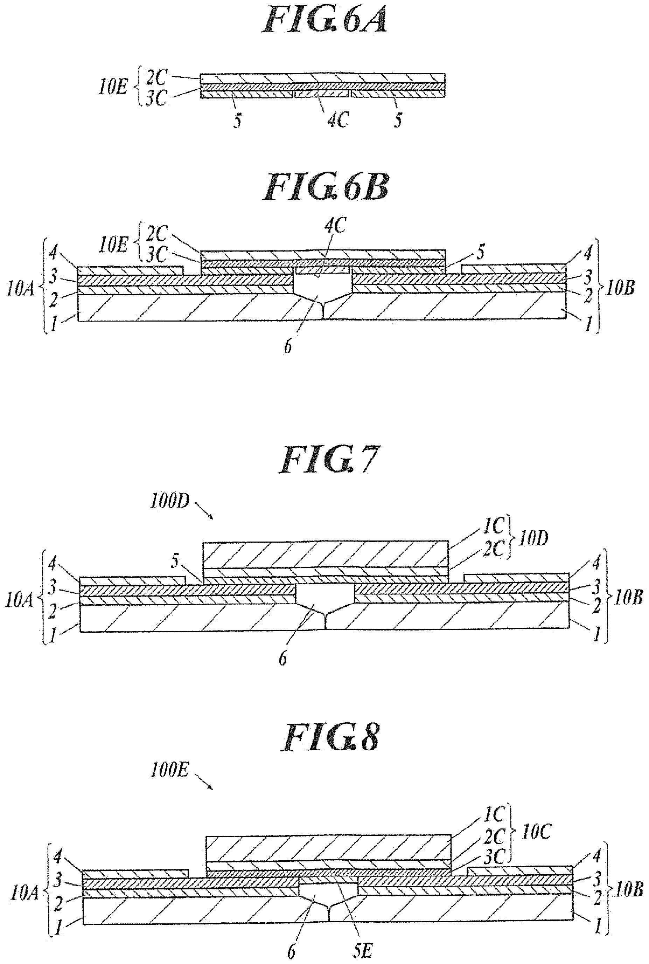

According to the superconducting wire rod connection structure 100, the connection wire rod can function as long as there is a superconducting conductor layer 3C, and the base material 1C is not a necessary configuration. That is, as shown in FIG. 6B, the exposed superconducting conductor layers 3, 3 of the first and second superconducting wire rods 10A, 10B can be connected bridged by a connection wire rod 10E including the intermediate layer 2C and the superconducting conductor layer 3C without the base material 1C.

The connection wire rod 10E has the same structure as the above-described connection wire rod 10C other than not including the base material 1C. Here, the connection wire rod 10E including the above-described stabilizing layer 4C is described.

The connection wire rod 10E can be formed from the superconducting wire rod with the same layer structure as the first and second superconducting wire rods 10A, 10B.

According to the connection method using the connection wire rod 10E, as shown in FIG. 6A, in the wire rod attaching method, the base material of the connection wire rod 10E is removed in advance by etching, and the stabilizing layer is removed by etching with only a portion as the stabilizing layer 4C remaining.

Then, as shown in FIG. 6B, the MOD liquid is applied on both sides of the superconducting conductor layer 3C other than the stabilizing layer 4C, and the connection superconducting film 5 is formed between the superconducting conductor layer 3C of the connection wire rod 10E and the superconducting conductor layers 3, 3 of the connection end of the first and second superconducting wire rods 10A, 10B in the film forming step.

The steps other than the above are the same as those of the connection method shown in the above-described FIG. 3A to FIG. 3F.

The connection method shown in FIG. 6A and FIG. 6B shows a method preparing the connection wire rod 10E with the base material removed in advance, and then connecting the connection wire rod 10E with the first and second superconducting wire rods 10A, 10B. Alternatively, the connection wire rod 10E with the base material remaining can be connected to the first and second superconducting wire rods 10A, 10B and then the base material of the connection wire rod 10E can be removed by etching.

The connection wire rod 10E can be used in other connection structures including the space 6 (separating portion), for example, 100E (FIG. 8E), 100G (FIG. 11), 100H (FIG. 12), 1001 (FIG. 13).

### [Second Example]

The superconducting conductor layer connection structure 100D which is the second example not forming part of the present invention is described in FIG. 7. The same reference numerals are applied to the configuration in the connection structure 100D which is the same as the above-described connection structure 100 and the redundant description is omitted.

According to the connection structure 100D, the connection wire rod 10D bridged on the superconducting conductor layers 3, 3 of the first and second superconducting wire rods 10A, 10B is different. The connection wire rod 10D is a layered body in which the intermediate layer 2C is layered on a main surface of the base material 1C (FIG. 7 shows a state in which the intermediate layer 2C is formed on the surface of the superconducting conductor layers 3, 3 side in the base material 1).

The connection wire rod 10D does not include the superconducting conductor layer 3C and the entire surface of the intermediate layer 2C is exposed throughout the entire length. Preferably, the surface roughness of the intermediate layer 2C of the connection wire rod 10D is made sufficiently small.

The connection method which forms the connection structure 100D is nearly the same as the connection method of the connection structure 100 and only the different points are described.

The process is the same from the exposing step to the welding step of the first and second superconducting wire rods 10A, 10B, and the connection wire rod 10D bridged on the superconducting conductor layers 3, 3 of the first and second superconducting wire rods 10A, 10B is prepared after the joining step.

Then, with the MOD liquid applied to the exposed surface of the intermediate layer 2C, the exposed surface of the intermediate layer 2C faces the exposed surface of the superconducting conductor layers 3, 3 of the first and second superconducting wire rods 10A, 10B, and the connection wire rod 10D is positioned on the superconducting conductor layers 3, 3 (wire rod attaching step) .

In this case, the MOD liquid can be applied to the exposed surface side of the superconducting conductor layers 3, 3 of the first and second superconducting wire rods 10A, 10B, and here, the MOD liquid also needs to be applied on the entire exposed surface of the intermediate layer 2C.

Then, the film forming step including the preliminary baking step and the main baking step, and the oxygen annealing step are performed under the same conditions as the connection structure 100, and the connection structure 100D is formed.

According to the superconducting wire rod connection structure 100D, due to the connection superconducting film 5, the superconducting critical current density in the superconducting conductor layers 3, 3 of the first and second superconducting wire rods 10A, 10B can be made sufficiently large, and the connection strength between the first and second superconducting wire rods 10A and 10B can be maintained at a high level.

Moreover, due to the space 6, the influence of the metallic element diffusion and the influence of the heat in welding can be reduced, and oxygen doping can be performed well on the superconducting conductor layers 3, 3 and the connection superconducting film 5 in the oxygen annealing step.

### [Third Example]

The superconducting conductor layer connection structure 100E which is the third example is described in FIG. 8. The same reference numerals are applied to the configuration in the connection structure 100E which is the same as the above-described connection structure 100 and the redundant description is omitted.

According to the connection structure 100E, the connection superconducting film 5E, which is formed between the superconducting conductor layers 3, 3 of the first and second superconducting wire rods 10A, 10B and the superconducting conductor layer 3C of the connection wire rod 10 is formed in a different range. The connection superconducting film 5E is formed only in the portion facing the space 6 on the surface of the superconducting conductor layer 3C of the connection wire rod 10C. That is, the connection superconducting film 5E comes into contact with the end surface of the connection end side of the superconducting conductor layers 3, 3 of the first and second superconducting wire rods 10A, 10B and the surface facing the space 6 of the superconducting conductor layer 3C of the connection wire rod 10C. With this, the superconducting critical current density between the superconducting conductor layers 3, 3 of the first and second superconducting wire rods 10A, 10B can be obtained.

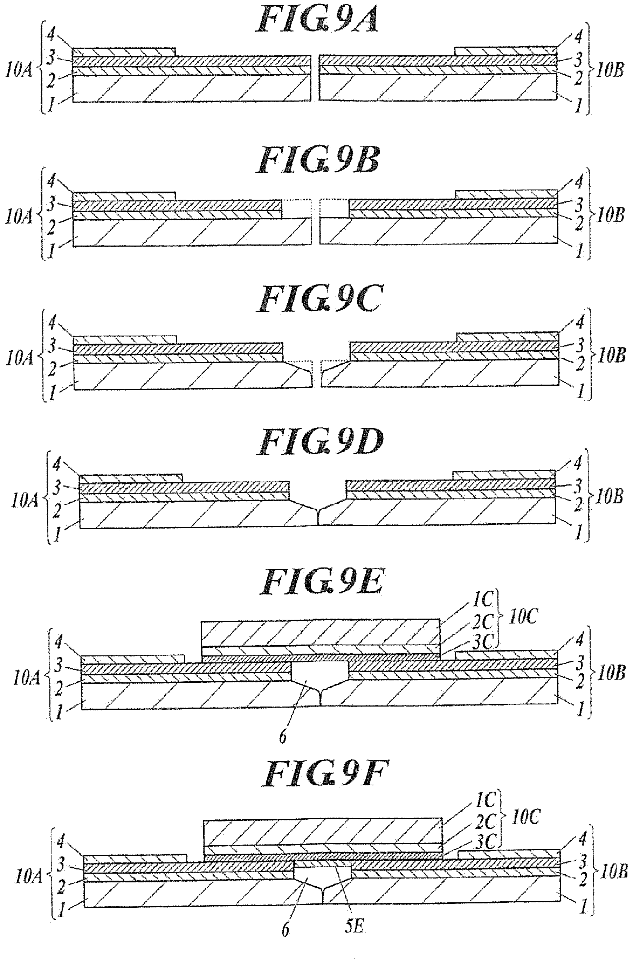

The superconducting wire rod connection method based on the connection structure 100E is shown in FIG. 9A to FIG. 9F.

The process from the exposing step to the joining step of the first and second superconducting wire rods 10A, 10B shown in FIG. 9A to FIG. 9D are the same as the superconducting wire rod connection method based on the connection structure 100, and therefore, the description is omitted.

Then, after the joining step, as shown in FIG. 9E, the connection wire rod 10C which bridges the superconducting conductor layers 3, 3 of the first and second superconducting wire rods 10A, 10B is prepared. Here, the MOD liquid is not applied to the exposed surface of the superconducting conductor layer 3C of the connection wire rod 10C, and the superconducting conductor layer 3C of the connection wire rod 10C comes into direct contact with the superconducting conductor layers 3, 3 of the first and second superconducting wire rods 10A, 10B and the above are connected to each other by heating and pressuring (wire rod attaching step). The connection between the layers of the superconducting conductor layers 3, 3 and 3C can be performed with a lower temperature compared with a technique such as the technique described in Japanese Patent No. 5214744 in which the superconducting conductor layer is heated to the melting point and joined.

Then, as shown in FIG. 9F, the space 6 is formed in the connection end of the first and second superconducting wire rods 10A, 10B by the wire rod attaching step.

The connection superconducting film 5E is formed to connect the superconducting conductor layers 3, 3 of the first and second superconducting wire rods 10A, 10B on the inner side of the space 6 (film forming step).

The connection superconducting film 5E can be formed by applying the MOD liquid on the entire surface on the inner side of the space 6 in the superconducting conductor layer 3C of the connection wire rod 10C, or the MOD liquid can be inserted in the space 6 to attach the MOD liquid on the surface on the inner side of the space 6 in the superconducting conductor layer 3C.

Then, under the same conditions as the above-described connection superconducting film 5, the preliminary baking step, the main baking step, and the oxygen annealing step are performed to form the connection superconducting film 5E.

According to the superconducting wire rod connection structure 100E, due to the connection superconducting film 5E, the superconducting critical current density of the superconducting conductor layers 3, 3 of the first and second superconducting wire rods 10A, 10B and the superconducting conductor layer 3C of the connection wire rod 10C can be made sufficiently large, and the connection strength of the first and second superconducting wire rods 10A, 10B can be maintained at a high level.

Further, due to the space 6, the influence of the metallic element diffusion and the influence of the heating in welding can be reduced, and oxygen doping can be performed well on the superconducting conductor layers 3, 3 and the connection superconducting film 5 in the oxygen annealing step.

Since the layers of the superconducting conductor layers 3, 3 and 3C are connected, the connection superconducting film 5E does not need to be formed. By providing the connection superconducting film 5E, it is possible to achieve the advantages such as the heating temperature of the oxygen annealing step can be made lower, and the superconducting critical current density can be made larger.

### [Fourth Example]

FIG. 10 shows the superconducting conductor layer connection structure 100F which is the fourth example. The same reference numerals are applied to the configuration of the connection structure 100F which is the same as the above-described connection structures 100D, 100E, and the redundant description is omitted.

According to the connection structure 100F, the above-described connection wire rod 10D is bridged between the superconducting conductor layers 3, 3 of the first and second superconducting wire rods 10A, 10B, and the above-described connection superconducting film 5 is formed between the superconducting conductor layers 3, 3 of the first and second superconducting wire rods 10A, 10B and the intermediate layer 2C of the connection wire rod 10D.

The connection method which forms the connection structure 100F is substantially the same as the connection method of the connection structure 100E, and only the different points are described.

The process from the exposing step to the joining step of the first and second superconducting wire rods 10A, 10B is the same, and after the joining step, the connection wire rod 10D which is bridged between the superconducting conductor layers 3, 3 of the first and second superconducting wire rods 10A, 10B is prepared.

Then, the exposed surface of the intermediate layer 2C of the connection wire rod 10D is positioned facing the exposed surface of the superconducting conductor layers 3, 3 of the first and second superconducting wire rods 10A, 10B, and the connection wire rod 10D is joined on the superconducting conductor layers 3, 3 (wire rod attaching step). The connection between the layers of the superconducting conductor layers 3, 3 and the intermediate layer 2C is merely a physical link between each other and the connection between layers to obtain conduction between each other is not established.

Then, the space 6 is formed in the connection ends of the first and second superconducting wire rods 10A, 10B by the wire rod attaching step.

On the inner side of the space 6, similar to the example shown in FIG. 9F, the connection superconducting film 5E is formed to connect the superconducting conductor layers 3, 3 of the first and second superconducting wire rods 10A, 10B (film forming step).

According to the superconducting wire rod connection structure 100F, due to the connection superconducting film 5, the superconducting critical current density in the superconducting conductor layers 3, 3 of the first and second superconducting wire rods 10A, 10B can be made sufficiently large, and the connection strength of the first and second superconducting wire rods 10A, 10B can be maintained at a high level.

Further, due to the space 6, the influence of the metallic element diffusion and the influence of the heat in welding can be reduced, and the doping of oxygen can be performed well on the superconducting conductor layers 3, 3 and the connection superconducting film 5 in the oxygen annealing step.

### [Fifth Example]

FIG. 11 shows the superconducting conductor layer connection structure 100G which is the fifth example. The same reference numerals are applied to the configuration of the connection structure 100G which is the same as the above-described connection structure 100, and the redundant description is omitted.

Such connection structure 100G is different from the connection structure 100 in that the space 6 is formed by removing only a portion of the connection end side of the superconducting conductor layers 3, 3 without removing the intermediate layers 2, 2 of the first and second superconducting wire rods 10A, 10B.

According to the connection structure 100G, in the above-described first removal step (see FIG. 3B), a portion of the connection end side of the superconducting conductor layers 3, 3 exposed by peeling the stabilizing layers 4, 4 of the first and second superconducting wire rods 10A, 10B is removed, and the surface of the connection ends of the intermediate layers 2, 2 is exposed. Such removal is performed by mechanical polishing, chemical polishing, or a combination of the above.

Moreover, the second removal step (see FIG. 3C) is not performed, and the base materials 1, 1 are connected by the joining step (see FIG. 3D).

Then, the wire rod attaching step, the film forming step, and the oxygen annealing step (if necessary, the stabilizing layer forming step, sealing step) are performed with the same method as the connection structure 100, and the connection structure 100G is formed.

According to the superconducting wire rod connection structure 100G, the second removal step is not necessary, and therefore, the connection structure can be formed easily.

Moreover, similar to the connection structure 100, due to the connection of the superconducting conductor layer 3C of the connection wire rod 10C, the superconducting critical current density can be made sufficiently large, and due to the welding of the base materials 1, 1, the connection strength in the connection structure can be maintained at a high degree.

Further, due to the space 6, the influence of the metallic element diffusion and the influence of the heat in welding can be reduced, and the doping of oxygen can be performed well on the superconducting conductor layers 3, 3 and the connection superconducting film 5 in the oxygen annealing step.

### [Sixth Example]

FIG. 12 shows a superconducting conductor layer connection structure 100H which is the sixth example. The same reference numerals are applied to the configuration of the connection structure 100H which is the same as the above-described connection structure 100G, and the description is omitted.

The connection structure 100H is different from the connection structure 100G in that the end surface of the terminal ends of the base materials 1, 1 of the first and second superconducting wire rods 10A, 10B is made tilted in a tilted surface instead of perpendicular to the longitudinal direction of the first and second superconducting wire rods 10A, 10B, and the tilted surfaces are joined.

According to the connection structure 100H, before the joining step (see FIG. 3D), a tilted surface is formed on each end surface of the connection ends of the base materials 1, 1 of the first and second superconducting wire rods 10A, 10B so as to fit each other. Then, after the tilted surfaces of the connection ends of the base materials 1, 1 of the first and second superconducting wire rods 10A, 10B are connected, the wire rod attaching step, the film forming step, and the oxygen annealing step (if necessary, the stabilizing layer forming step and the sealing step) are performed with the same method as the connection structure 100G, and the connection structure 100H is formed.

According to the superconducting wire rod connection structure 100H, the same effects as the connection structure 100G can be achieved. Further, since the connection ends of the base materials 1, 1 of the first and second superconducting wire rods 10A, 10B are joined with a tilted surface, the area (square dimension) of the joined area can be made larger, and the connection strength of the first and second superconducting wire rods 10A, 10B can be further enhanced.

According to the connection structure 100H, only a portion of the connection end side of the superconducting conductor layers 3, 3 of the first and second superconducting wire rods 10A, 10B is removed to form the space 6, but a portion of the connection end side of the intermediate layers 2, 2 can also be removed.

### [Seventh Example]

FIG. 13 shows a superconducting conductor layer connection structure 100I which is the seventh example. The same reference numerals are applied to the configuration of the connection structure 100I which is the same as the above-described connection structure 100, and the redundant description is omitted.

The connection structure 100I is different from the connection structure 100 in that a surface on the opposite side of the main surface of one base material 1, and a main surface of the other base material 1 are joined instead of joining the end surfaces of the connection ends of the base materials 1, 1 of the first and second superconducting wire rods 10A, 10B.

According to the connection structure 100I, in the above-described first removal step (see FIG. 3B), a portion of the connection end side of the superconducting conductor layer 3 and the intermediate layer 2 of the first superconducting wire rod 10B which is the lower side is removed instead of removing the superconducting conductor layer 3 and the intermediate layer 2 of the first superconducting wire rod 10A which is the upper side.

Here, the range that the superconducting conductor layer 3 and the intermediate layer 2 of the first superconducting wire rod 10B is removed is to be the sum of the length of the space 6 and the length of the overlapped portions of the base materials 1, 1. Such removal is performed by mechanical polishing, chemical polishing, or a combination thereof.

Moreover, the second removal step (see FIG. 3C) is not performed. In the joining step (see FIG. 3D), the surface opposite of the main surface of the base material 1 of the first superconducting wire rod 10A is overlapped facing the exposed main surface of the base material 1 of the second superconducting wire rod 10B, and the faces facing each other are joined by welding.

Then, the connection wire rod 10C is prepared, and the superconducting conductor layer 3C is placed facing downward. In the wire rod attaching step (see FIG. 3F), the connection superconducting film 5 is formed and one end is connected to the superconducting conductor layer 3 of the first superconducting wire rod 10A and the other end is connected to the superconducting conductor layer 3 of the second superconducting wire rod 10B. Here, there is a difference in height between the superconducting conductor layer 3 of the first superconducting wire rod 10A and the superconducting conductor layer 3 of the second superconducting wire rod 10B, and in order to cope with the above, the connection is performed with the connection wire rod 10C sagging in a crank shape.

Then, the film forming step and the oxygen annealing step (if necessary, the stabilizing layer forming step and sealing step) are performed with the same method as the connection structure 100 to form the connection structure 100I.

According to the superconducting wire rod connection structure 100I, the second removal step becomes unnecessary and the connection structure can be formed easily.

Since there is a difference in height between the superconducting conductor layer 3 of the first superconducting wire rod 10A and the superconducting conductor layer 3 of the second superconducting wire rod 10B, a space 6 can be easily formed as a separating portion with a sufficient length separating the connection ends of the first and second superconducting wire rods 10A, 10B with the connection wire rod 10C.

Similar to the connection structure 100, the superconducting critical current density can be made sufficiently large by the connection of the superconducting conductor layer 3C of the connection wire rod 1C, and the connection strength in the connection structure can be maintained at a high degree by the welding of the base materials 1, 1.

Further, due to the space 6, the influence of the metallic element diffusion and the influence of the heat in welding can be reduced, and the doping of oxygen can be performed well on the superconducting conductor layers 3, 3 and the connection superconducting film 5 in the oxygen annealing step.

### [Other superconducting wire rods]

The connection structure of the superconducting wire rod 15 used in the following examples and embodiments is described.

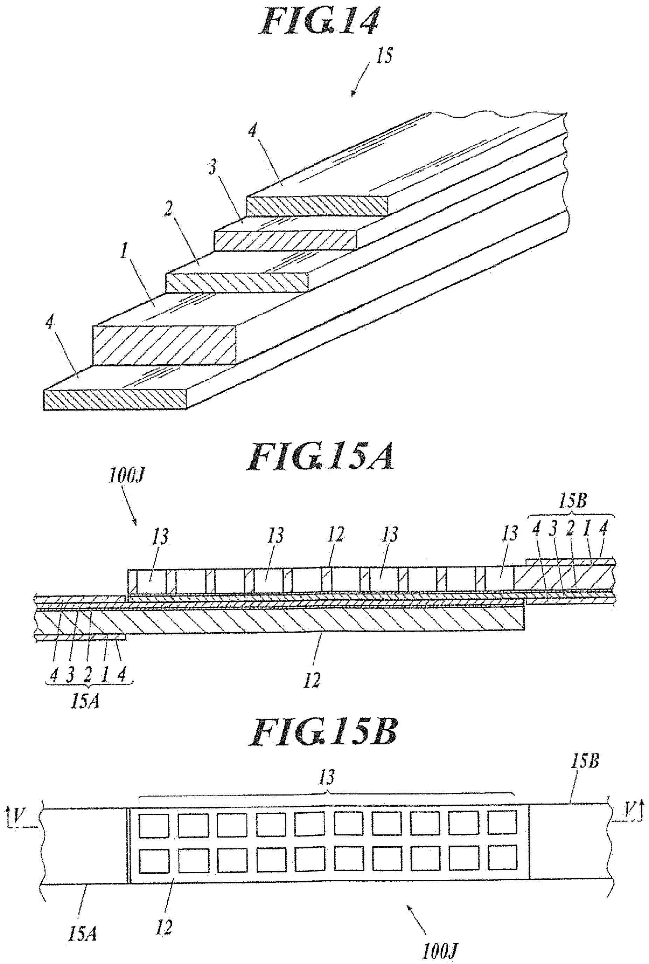

FIG. 14 is a perspective view of the superconducting wire rod 15. The same reference numerals are applied to the configuration of the superconducting wire rod 15 which is the same as the above-described superconducting wire rod 10, and the redundant description is omitted.

As shown in FIG. 14, the superconducting wire rod 15 is different from the superconducting wire rod 10 in that the intermediate layer 2, the oxide superconducting conductor layer 3, and the stabilizing layer 4 are layered in order on one main surface in the thickness direction of the base material 1, and on the surface opposite of the film forming surface 11 of the base material 1 (hereinafter referred to as "back surface 12"), the stabilizing layer 4 is formed.

Preferably, the intermediate layer 2 includes the Al₂O₃ (alumina) layer regardless of whether the structure is a single-layer structure or a multi-layer structure.

The stabilizing layers 4, 4 cover the surface of the superconducting conductor layer 3 and the back surface 12 of the base material 1, and preferably, the stabilizing layers 4, 4 cover the entire surroundings of the base material 1, the intermediate layer 2, and the superconducting conductor layer 3.

The superconducting wire rods 10, 10A, 10B or the connection superconducting wire rod 10C in the connection structures 100 to 100I of the first to seventh examples have the same structure as the superconducting wire rod 15.

### [Superconducting wire rod connection structure]

The superconducting wire rod connection structure 100J which is the eighth example is formed by a later-described connection method connecting the connection ends of the first and second superconducting wire rods 15A, 15B overlapping each other as shown in FIG. 15A. The first and second superconducting wire rods 15A, 15B have the same structure as the superconducting wire rod 15, and the same reference numerals as the superconducting wire rod 15 are used for the layers 1 to 4.

According to the connection structure 100J, the exposed flat surfaces of the superconducting conductor layers 3, 3 of the first and second superconducting wire layers 15A, 15B are joined facing each other, and openings 13 are formed on the back surface 12 of the base material 1 of the second superconducting wire rod 15B at a depth which does not penetrate the superconducting conductor layers 3, 3.

As shown in FIG. 15B, the opening 13 is a substantial rectangle from a planar view, and a plurality of openings 13 are formed in two lines along the longitudinal direction of the base material 1.

The opening 13 is formed from the back surface 12 of the base material 1 to reach a depth to the intermediate layer 2.

### [Superconducting wire rod connection method]

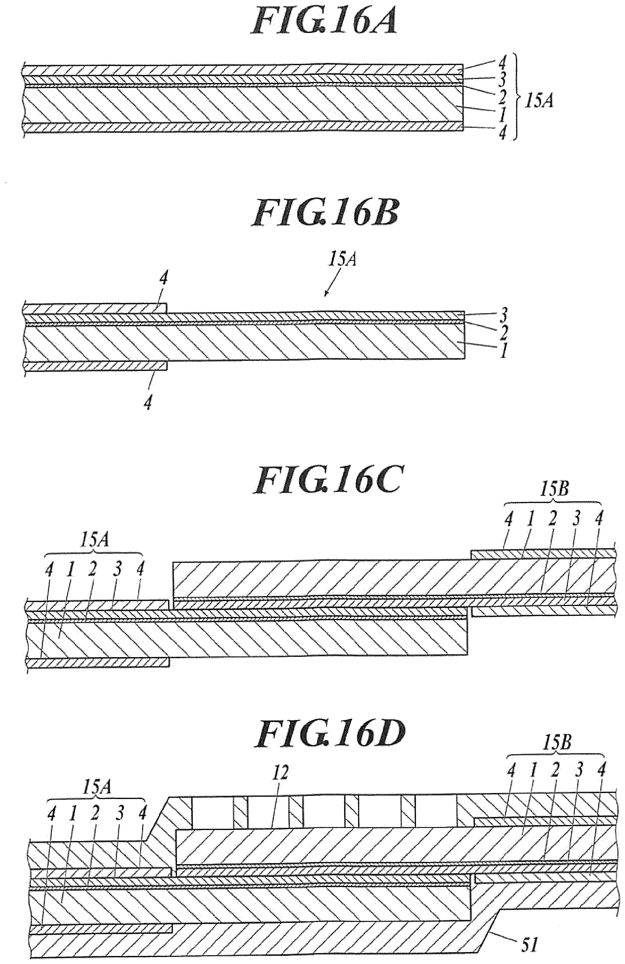

The connection method of the connection structure 100J is described in the order of the steps based on FIG. 16A to FIG. 16E.

First, as shown in FIG. 16A, the first and second superconducting wire rods 15A, 15B are prepared. The illustration of the second superconducting wire rod 15B is omitted in FIG. 16A and FIG. 16B.

Then, as shown in FIG. 16B, the superconducting conductor layers 3, 3 are exposed by removing the stabilizing layers 4, 4 on the superconducting conductor layer 3 side and on the back surface 12 side of the base material 1 in the connection end of the first and second superconducting wire rods 15A, 15B (exposing step). The removal of the stabilizing layers 4 is performed by mechanical polishing, chemical polishing, or a combination of the above.

Preferably, the surface roughness of the superconducting conductor layer 3 exposed by peeling the stabilizing layer 4 is made small in order to enable a good joining between the superconducting conductor layers (for example, about 10 nm).

Next, as shown in FIG. 16C, the exposed planar surfaces of the superconducting conductor layers 3, 3 of the first and second superconducting wire rods 15A, 15B are positioned facing each other and the superconducting conductor layers 3, 3 are joined with each other (joining step) .

Here, a superconducting conductor (not illustrated) is formed by the MOD method (Metal Organic Deposition method) between the superconducting conductor layers 3, 3 of the first and second superconducting wire rods 15A, 15B to join the above.

Therefore, the above-described joining step includes the step to apply the MOD liquid which is to be a precursor of the superconducting conductor according to the MOD method on one or both of the surface of the superconducting conductor layer 3 of the first superconducting wire rod 15A and the surface of the superconducting conductor layer 3 of the second superconducting wire rod 15B.

For example, the above-described MOD liquid used is an acetylacetonate type solution including RE (rare earth element such as Y (yttrium), Gd (gadolinium), Sm (samarium), and Ho (holmium)), Ba, and Cu in a ratio of about 1:2:3.

Moreover, the above-described joining step includes a preliminary baking step to remove organic components included in the MOD liquid applied on either one or both of the first superconducting wire rod 15A and the second superconducting wire rod 15B, and a main baking step to join the superconducting conductor layers 3, 3 by epitaxial growth on the interface of the superconducting conductor layers 3, 3 of the first and second superconducting wire rods 15A, 15B.

The preliminary baking step performs thermal processing on the joining portion of the first and second superconducting wire rods 15A, 15B within the temperature range of 400°C or higher and 500° or lower while applying pressure within the range of 10 to 100 MPa.

The main baking step performs thermal processing on the joining portion of the first and second superconducting wire rods 15A, 15B within the temperature range of 780°C or higher and 830°C or lower while applying pressure within the range of 10 to 100 MPa.

Such pressure conditions and temperature conditions are merely one example and do not limit the range of the values.

Next, the openings 13 are formed by etching on the back surface 12 of the base material 1 of the second superconducting wire rod 15B at a depth which reaches the intermediate layer 2 (opening step).

The etching includes a mask forming step so that the portions of the base material 1 other than the openings 13 remain and a removal step to remove a portion of the base material 1 according to the mask.

As shown in FIG. 16D, in the mask forming step, the entire connection portion between the first and second superconducting wire rods 15A, 15B is covered by an etching resist 51 and the etching resist 51 is exposed to a predetermined short wavelength energy ray according to the forming pattern of the plurality of openings 13. Then, the resist of the exposed portion is removed by the developing liquid of the etching resist 51, and the mask is formed. The positive-type etching resist is described here, but a negative-type etching resist 51 can also be used. In this case, the portion other than the forming pattern of the plurality of openings 13 is exposed.

In the removal step, the portion other than the portion masked by the etching resist 51 is dipped in the etching liquid to form the plurality of openings 13 from the back surface 12 side of the base material 1. The etching liquid which dissolves the base material 1 but does not dissolve the intermediate layer 2 is used. With this, the dissolving by the etching liquid is stopped at the intermediate layer 2.

For example, when the base material 1 is formed from Hastelloy (registered trademark) which is a NiCr alloy, preferable openings can be made if an etching liquid including nitric acid, sulfuric acid, and hydrogen peroxide water with a ratio of 20-30%, 1-5%, and 0.5-2%, respectively, is used. The range of the values is merely one example and other suitable values can be selected.

As described above, when the intermediate layer 2 includes an Al₂O₃ layer, the intermediate layer 2 is not dissolved by the above etching liquid, and at least the openings 13 do not progress toward the superconducting conductor layer 3 side past the Al₂O₃ layer.

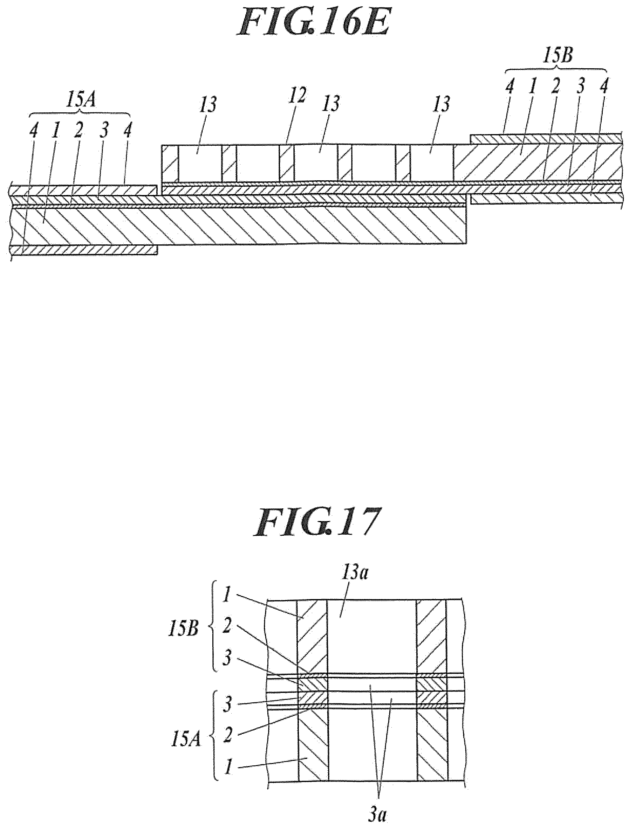

Next, as shown in FIG. 16E, the oxygen annealing step is performed to remove the etching resist 51, and to dope oxygen on the superconducting conductor layers 3, 3 of the first and second superconducting wire rods 15A, 15B. The oxygen annealing step is performed by storing the superconducting conductor layers 3, 3 of the first and second superconducting wire rods 15A, 15B in an oxygen atmosphere within a temperature range of 350°C or higher and 500°C or lower within a predetermined amount of time.

After the oxygen annealing step, a stabilizing layer forming step can be added. Here, the silver stabilizing layer can be formed by vapor deposition of silver or applying and then baking silver paste on the surface of the connection portion. Then, the copper stabilizing layer can be formed by electroplating.

All connection structures 100J to 100M (later-described) including the openings 13 or 13C (later-described) can include a filling step after the oxygen annealing step or between the oxygen annealing step and the stabilizing layer forming step to fill resin in the openings 13 or 13C. Preferably, the resin is a type which hardens later. With this, the portions formed with the openings 13 or 13C which tend to decrease the strength is filled with resin to enhance the strength of the structure.

According to the above steps, the superconducting wire rod connection structure 100J is formed.

The above-described example of the connection method shows the opening step performed between the joining step and the oxygen annealing step. The opening step can be performed any time before the oxygen annealing step in a state that the surface opposite of the superconducting conductor layer 3 of the base material 1 on which the openings 13 are formed is exposed. For example, the opening step can be performed between the exposing step and the joining step.

In this case, the connection end of the second superconducting wire rod 15B with the superconducting conductor layer 3 exposed is covered with the etching resist 51, and the above is exposed according to the forming pattern of the openings 13 to form a mask (mask forming step). Then, the connection end of the second superconducting wire rod 15B is dipped in the etching liquid to form a plurality of openings 13 up to the intermediate layer 2 (removal step).

Then, after the etching resist 51 is removed, similar to the above, the superconducting conductor layer 3 of the first superconducting wire rod 15A and the superconducting conductor layer 3 of the second superconducting wire rod 15B are connected by the joining step. Then, as described above, the oxygen doping is performed in the oxygen annealing step similar to the above, and the stabilizing layer forming step is performed as necessary.

The connection structure 100J can be formed by the above connection method.

### [Technical effect of eighth example]

According to the above-described superconducting wire rod connection structure 100J, a plurality of openings 13 reaching the intermediate layer 2 are provided on the back surface 12 of the base material 1 of the second superconducting wire rod 15B in the first and second superconducting wire rods 15A, 15B with the superconducting conductor layers 3, 3 joined facing each other.

Therefore, when the superconducting conductor layers 3, 3 of the first and second superconducting wire rods 15A, 15B are joined and oxygen annealing is performed, the oxygen is supplied to the superconducting conductor layers 3, 3 by the openings 13 without being blocked by the base material 1. With this, oxidizing can be performed effectively. Therefore, the superconductivity of the superconducting layers 3, 3 of the first and second superconducting wire rods 15A, 15B can be maintained at a high level. The time necessary for oxygen annealing can be made shorter.

A plurality of openings 13 are formed along a longitudinal direction of the second superconducting wire rod 1B. Therefore, the strength of the base material 1 can be adjusted suitably by adjusting the interval.

The openings 13 are formed by etching and therefore, the openings 13 which do not penetrate the superconducting conductor layers 3 can be easily formed.

For example, the openings can be formed by laser processing. In such case, as shown in FIG. 17, the openings 13a are formed penetrating the intermediate layer 2 and the superconducting conductor layer 3. When the openings 13a penetrate the superconducting conductor layer 3, even if oxygen annealing is performed and the oxygen is supplied in the openings 13a, only the fine end surface 3a of the superconducting conductor layer 3 on the inner side of the openings 13a is treated with oxygen, and the oxidation is not sufficiently performed. Therefore, the superconductivity of the superconducting conductor layers 3, 3 of the connection structure cannot be maintained at a sufficiently high level.

Turning to the openings 13 formed by etching, the internal base surface is large, and oxidation of the superconducting conductor layer 3 can be performed sufficiently compared to processing by laser. Therefore, it is possible to maintain superconductivity of the superconducting conductor layers 3, 3 of the connection structure 100J at a higher level.

When the bed layer of the intermediate layer 2 includes Al₂O₃, etching can be performed short of the Al₂O₃ layer. Since Al₂O₃ has high oxygen permeability compared to other metals, the oxidation of the superconducting conductor layer 3 can be sufficiently performed. With this, the superconductivity of the superconducting conductor layers 3, 3 of the connection structure can be maintained at a high level.

The joining step of the superconducting conductor layers 3, 3 includes a step to apply the MOD solution as the precursor of the oxide superconducting conductor on one or both of the superconducting conductor layers 3, 3 of the first and second superconducting wire rods 15A, 15B and a step to bake the precursor of the superconducting conductor.

With this, in the joining step, the superconducting conductor can be formed between the superconducting conductor layers 3, 3 of the first and second superconducting wire rods 15A, 15B and the superconducting conductors 3, 3 can be connected with a sufficiently large superconducting critical current density between each other.

According to the above example, in the connection end side of the first and second superconducting wire rods 15A, 15B, the stabilizing layers 4, 4 on the superconducting conductor layer 3 side and the back surface 12 side of the base material 1 are removed, but the present invention is not limited to the above. For example, when only the base material 1 of the second superconducting wire rod 15B is removed by etching, the stabilizing layer 4 of the base surface 12 side of the base material 1 of the first superconducting wire rod 15A can be left without removal.

### [Reinforcing member]

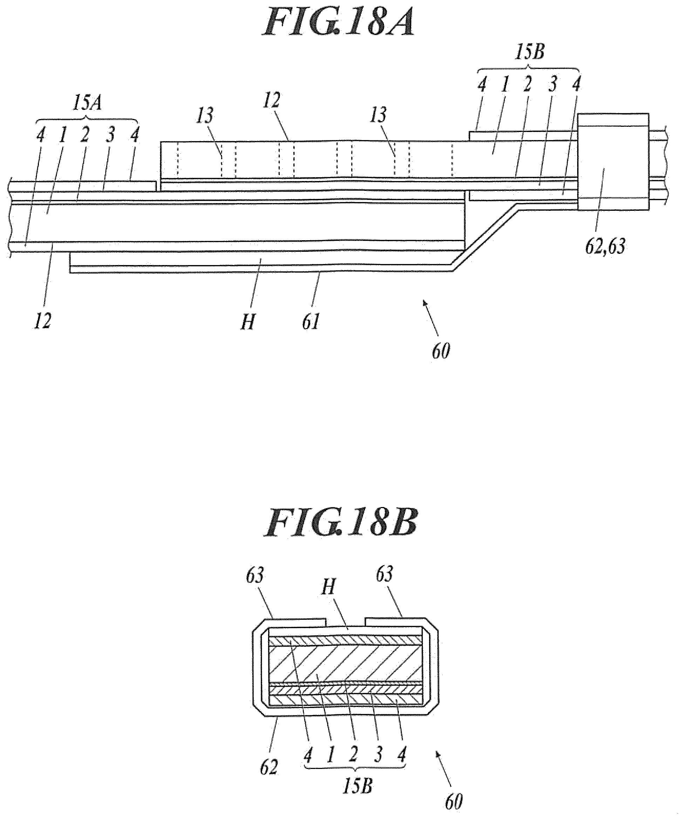

The superconducting wire rod connection structure 100J connects the wire rods by joining the superconducting conductor layers 3, 3 of the first and second superconducting wire rods 15A, 15B. Since the superconducting conductor layers 3, 3 peel easily, as shown in FIG 18A and FIG. 18B, the reinforcing member 60 can be added to the superconducting wire rod connection structure 100J and the connection strength can be enhanced.

The reinforcing member 60 is placed with one end 61 and the other end 62 each linked individually to the first and second superconducting wire rods 15A, 15B so as to avoid the openings 13 formed in the second superconducting wire rod 15B and so that the openings are in between the one end 61 and the other end 62 in the longitudinal direction of the wire rod.

The one end 61 of the reinforcing member 60 is a long plate shape, and the plane surface is joined to the outer side surface of the stabilizing layer 4 formed on the back surface 12 of the base material 1 of the first superconducting wire rod 15A by soldering. Reference numeral H in FIG. 18A and FIG. 18B show the soldering.

The other end 62 of the reinforcing member 60 includes a pair of arms 63, 63 which surround the outer side surface of the stabilizing layer 4 formed on the back surface 12 of the base material 1 of the second superconducting wire rod 15B. The inner side surfaces of the arms 63, 63 are joined to the outer side surface of the stabilizing layer 4 by soldering.

The other end 62 of the reinforcing member 60 is not joined to the stabilizing layer 4 on the superconducting conductor layer 3 side of the second superconducting wire rod 15B, and maintains a non-contacting state by providing a space. If the other end 62 of the reinforcing member 60 joins the stabilizing layer 4 on the superconducting conductor layer 3 side, the superconducting conductor layer 3 may peel off or break through the stabilizing layer 4 when the first and second superconducting wire rods 15A, 15B receive tension. Therefore, the other end 62 of the reinforcing member 60 is joined to the stabilizing layer 4 on the back surface 12 side of the base material 1 in which the influence of the tension is small.

The other end 62 of the reinforcing member 60 is joined in a position separated from the connection end of the second superconducting wire rod 15B than the forming position of the plurality of openings 13. With this, it is possible to prevent the joining portion of the other end 62 of the reinforcing member 60 from closing the opening 13.

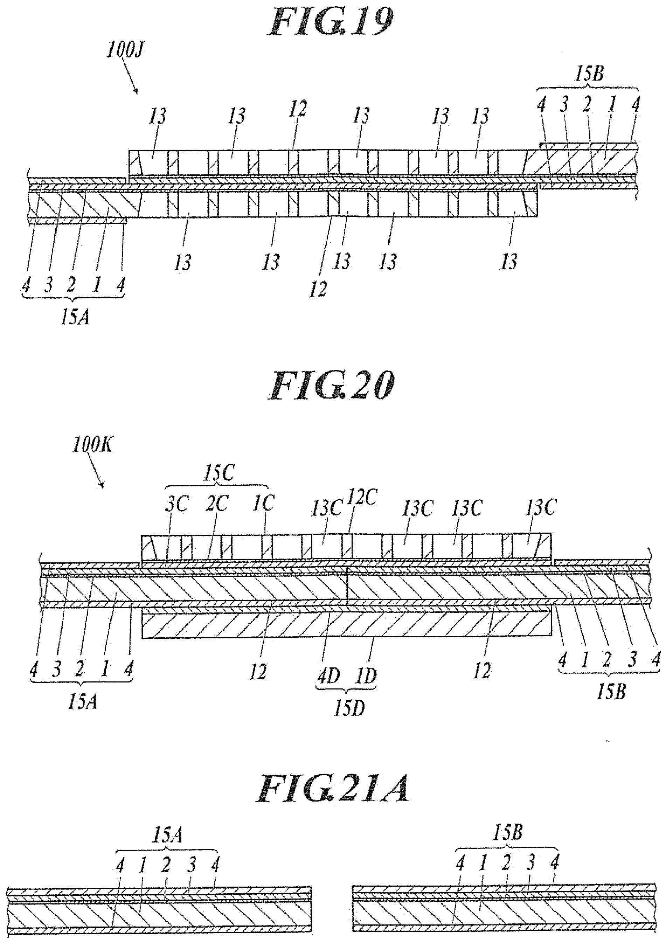

As in the examples described below, preferably, when the opening 13 is formed in the base material 1 of the first superconducting wire rod 15A also (see FIG. 19), it is preferable to join the one end 61 of the reinforcing member 60 in a position separated from the connection end of the second superconducting wire rod 15B than the forming position of the plurality of openings 13.

### [Example providing an opening on both surfaces]

The above example shows the openings 13 provided on only the second superconducting wire rod 15B, but as shown in FIG. 19, the openings 13 can also be formed on the first superconducting wire rod 15A. In this case also, a plurality of openings 13 are formed from the back surface 12 of the base material 1 of the first superconducting wire rod 15A to the intermediate layer 2.

With this, when oxygen is annealed, oxygen is supplied to the superconducting conductor layers 3, 3 from the openings 13 on the first superconducting wire rod 15A side, and with this, it is possible to promote oxidization more effectively and to maintain the superconductivity of the superconducting conductor layers 3, 3 highly. Moreover, the time necessary for oxygen annealing can be made shorter.

When the openings 13 are formed on both the first and second superconducting wire rods 15A, 15B, the strength of the base materials 1, 1 reduce. Therefore, the above-described reinforcing members 60 are effective to protect the superconducting conductor layers 3, 3.

### [Ninth Example]

According to the above-described superconducting wire connection structure 100J, the connection ends of the first and second superconducting wire rods 15A, 15B are positioned overlapped and connected with the superconducting conductor layers 3, 3 facing each other, but the connection method is not limited to the above.

The ninth example is an example of a superconducting wire rod connection structure 100K in which the third superconducting wire rod 15C which is the connection superconducting wire rod is used to connect the first and second superconducting wire rods 15A, 15B in a bridging state.

As shown in FIG. 20, the superconducting wire rod connection structure 100K includes a third superconducting wire rod 15C in which each end is overlapped with different connection ends to be connected with the first and second superconducting wire rods 15A, 15B, and openings 13C are provided on the third superconducting wire rods 15C.

The openings 13C can be provided on the first and second superconducting wire rods 15A, 15B side.

Preferably, according to the superconducting wire rod connection structure 100K, a reinforcing wire rod 15D including a stabilizing layer 4D and base material 1D is attached bridging the stabilizing layers 4, 4 on the back surfaces 12, 12 sides of the base materials 1, 1 of the first and second superconducting wire rods 15A, 15B.

### [Superconducting wire rod connection method]

FIG. 21A to FIG. 21E show the superconducting wire rod connection method based on the superconducting wire rod connection structure 100K. The connection method is described in order of each step.

First, as shown in FIG. 21A, the first and second superconducting wire rods 15A, 15B are prepared.

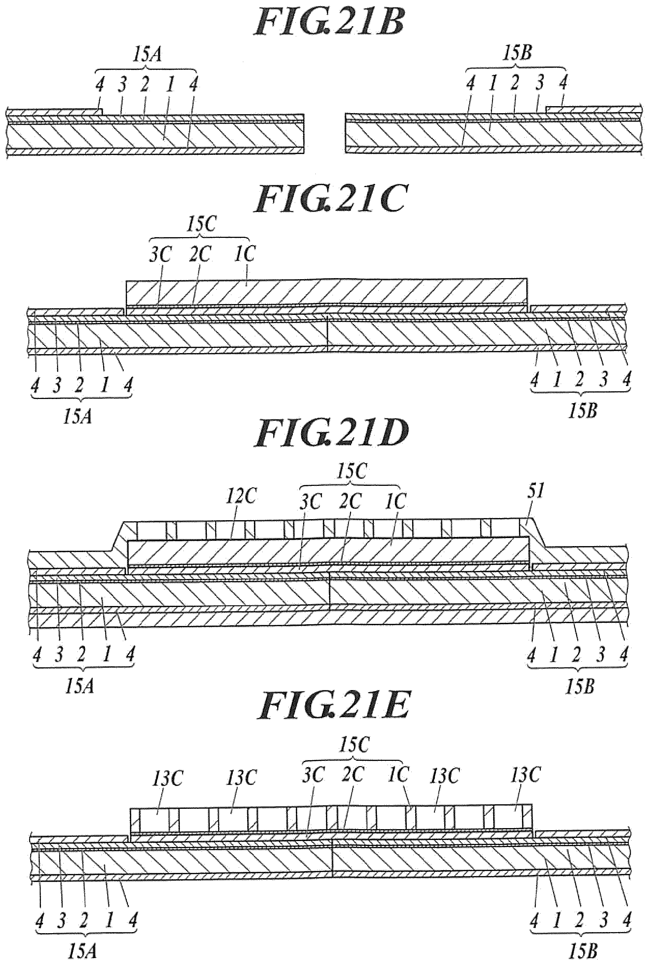

Then, as shown in FIG. 21B, the stabilizing layer 4 on the superconducting conductor layer 3 side is removed in the connection end side of the first and second superconducting wire rods 15A, 15B to expose the superconducting conductor layers 3, 3 (exposing step). The removal of the stabilizing layer 4 is performed by mechanical polishing, chemical polishing, or a combination of the above.

The stabilizing layer 4 on the back surface 12 side of the base material 1 is left as is without being removed in order to attach the reinforcing wire rod 15D shown in FIG. 20.

Similar to the superconducting wire rod connection structure 100J, the surface roughness of the exposed superconducting conductor layer 3 should be made small.

Next, as shown in FIG. 21C, the third superconducting wire rod 15C is positioned so that the superconducting conductor layer 3C of the third superconducting wire rod 15C faces the exposed superconducting conductor layers 3, 3 of the first and second superconducting wire rods 15A, 15B. The third superconducting wire rod 15C includes a base material 1C, intermediate layer 2C, and a superconducting conductor layer 3C. The above are the same material as the base material 1, the intermediate layer 2, and the superconducting conductor layer 3 of the first and second superconducting wire rods 15A, 15B.

Then, the superconducting conductor layers 3, 3 of the first and second superconducting wire rods 15A, 15B are joined to the superconducting conductor layer 3C of the third superconducting wire rod 15C (joining step).

The MOD method which is the same as the method used in the superconducting wire rod connection structure 100J is used to join the superconducting conductor layers 3, 3 of the first and second superconducting wire rods 15A, 15B with the superconducting conductor layer 3C of the third superconducting wire rod 15C.

Next, the opening 13C is formed on the back surface 12C of the base material 1C of the third superconducting wire rod 15C with a depth reaching the intermediate layer 2C by etching (opening step).

The openings 13C are formed in a process the same as the step of forming the opening 13 of the above-described superconducting wire rod connection structure 100J.

That is, the etching includes the mask forming step and the removal step.

According to the mask forming step, as shown in FIG. 21D, the entire connection portions of the first to third superconducting wire rods 15A to 15C are covered by the etching resist 51. The above is exposed according to the forming pattern of the plurality of openings 13C, and the resist of the exposed portion is removed to form the mask.

In the removal step, the above is dipped in the etching liquid and the plurality of openings 13C are formed from the back surface side of the base material 1C according to the mask by the etching resist 51. In this case also, the opening 13C is formed up to the intermediate layer 2C.

Next, as shown in FIG. 21E, the oxygen annealing step is performed, in which the etching resist 51 is removed and the superconducting conductor layers 3, 3, 3C of the first to third superconducting wire rods 15A to 15C are doped by oxygen. The conditions of oxygen annealing are the same as the superconducting wire rod connection structure 100J.

Then, the silver stabilizing layer is formed by vapor deposition of silver or applying silver paste on the surface of the connection portion and then baking. The stabilizing layer forming step is performed to form the copper stabilizing layer on the above by electric field coating method. Here, the stabilizing layer can be formed so as to fill the opening 13C.

Next, the reinforcing wire rod attaching step is performed, in which the reinforcing wire rod 15D including the stabilizing layer 4D and the base material 1D is attached on the outer side surface of the stabilizing layer 4 on the back surface 12 side of the base material 1 of the first and second superconducting wire rods 15A, 15B (see FIG. 20).

The stabilizing layer 4D and the base material 1D of the reinforcing wire rod 15D are made from the same material as the stabilizing layer 4 and the base material 1 of the first and second superconducting wire rods 15A, 15B.

The reinforcing wire rod 15D is positioned so that the stabilizing layer 4D faces the stabilizing layers 4 of the first and second superconducting wire rods 15A, 15B, and the stabilizing layers 4, 4D are joined. For example, when the stabilizing layers 4, 4D are silver stabilizing layers, the layers are joined by Ag-Ag diffusion joining.

Then, the superconducting wire rod connection structure 100K is formed by the above steps.

Regarding the above-described connection method similar to the examples shown in FIG. 16A to FIG. 16E, the opening step can be performed before the oxygen annealing step. Especially, in the connection structure 100K, the opening step can be performed before the exposing step or the joining step. That is, similar to the above-described opening step, a plurality of openings 13C are formed on the surface of the opposite side of the superconducting conductor layer 3C in the base material 1C of the third superconducting wire rod 15 by etching, and then the exposing step or the joining step can be performed.

### [Technical effect of ninth example]

Similar to the superconducting wire rod connection structure 100J, according to the superconducting wire rod connection structure 100K, oxygen is supplied to the superconducting conductor layers 3, 3, 3C by the openings 13C, and the oxidization can be promoted efficiently. Therefore, the superconductivity of the superconducting conductor layers 3, 3, 3C of the first to third superconducting wire rods 15A to 15C can be maintained at a high level. Moreover, the time necessary for oxygen annealing can be shortened.

Moreover, the same effects as the superconducting wire rod connection structure 100J can be obtained due to forming the openings 13C aligned in the longitudinal direction of the superconducting wire rods 15A to 15C, forming the openings 13C by etching, the intermediate layer 2 being provided with the bed layer including Al₂O₃, using the MOD method to join the superconducting conductor layers 3, 3, 3C, and the like.

### [Tenth Example]

FIG. 22 shows the superconducting wire rod connection structure 100L which is the tenth example. The same reference numerals are used for the configuration of the connection structure 100L which is the same as the above-described connection structure 100 or 100K and the description is omitted.

The connection structure 100L has the same configuration as the connection structure 100K. That is, the connection structure 100L includes a third superconducting wire rod 15C in which each end is overlapped with different connection ends to be connected with the first and second superconducting wire rods 15A, 15B, and a plurality of openings 13C are provided on the surface opposite of the superconducting conductor layer 3C in the base material 1C of the third superconducting wire rod 15C in two rows along the longitudinal direction of the wire rod at a depth which does not penetrate the superconducting conductor layer 3C. The reinforcing wire rod 15D is provided bridging the stabilizing layers 4, 4 on the back surfaces 12, 12 sides of the base materials 1, 1 of the first and second superconducting wire rods 15A, 15B.

Then, in the connection structure 100L, a space 6 as a separated portion formed by separating the connection ends of the first and second superconducting wire rods 15A, 15B from the third superconducting wire rod 15C is provided between the connection ends of the first and second superconducting wire rods 15A, 15B joined by the joining portion of the base materials 1, 1 and the third superconducting wire rod 15C as the connection wire rod.

The connection structure 100L performs the same method as the exposing step, first removal step, second removal step, joining step, and wire rod attaching step performed in the above-described connection structure 100 (see FIG. 3A to FIG. 3F) to form the connection between the first and second superconducting wire rods 15A, 15B, the connection of the superconducting conductor layers 3, 3 of the above by the third superconducting wire rod 15C, and the space 6.

Further, the same method as the opening step, oxygen annealing step, stabilizing layer forming step, and reinforcing wire rod attaching step (see FIG. 21D, FIG. 21E, FIG. 20) of the above-described connection structure 100K are performed to form the opening 13C and to join the reinforcing wire rod 15D.

In the above-described connection method also, similar to the examples shown in FIG. 16A to FIG. 16E, the opening step can be performed before the oxygen annealing step. Specifically, according to the connection structure 100L, the opening step can be performed before the exposing step, first removal step, second removal step, joining step or the wire rod attaching step. That is, similar to the above-described opening step, a plurality of openings 13C can be formed on the surface opposite of the superconducting conductor layer 3C in the base material 1C of the third superconducting wire rod 15 by etching, and then, the exposing step, first removal step, second removal step, joining step or wire rod attaching step can be performed.

According to the superconducting wire rod connection structure 100L, similar to the connection structure 100K, the oxygen annealing can be performed effectively, and the superconductivity of the superconducting conductor layers 3, 3, 3C of the first to third superconducting wire rods 15A to 15C can be maintained at a high level, and the time necessary for oxygen annealing can be shortened.

Similar to the connection structure 100, the superconducting critical current density can be made sufficiently large by the connection of the superconducting conductor layer 3C of the third superconducting wire rod 15C, and the connection strength in the connection structure can be maintained at a high level by the welding of the base materials 1, 1.

Moreover, it is possible to achieve reduction of influence of metallic element diffusion in the space 6 and the influence of heat in welding, and good doping of oxygen on the superconducting conductor layers 3, 3 and connection superconducting film 5 in the oxygen annealing step.

### [Embodiment]

The superconducting wire rod connection structure 100M which is an embodiment is described in FIG. 23. The same reference numeral is applied to the configuration of the connection structure 100M which is the same as the above-described connection structure 100L, and the redundant description is omitted.

The connection structure 100M is different from the connection structure 100L in that the openings 13C formed on the third superconducting wire rod 15C is formed penetrating the entire third superconducting wire rod 15C and the entire first and second superconducting wire rods 15A, 15B.

According to the connection structure 100M, in the opening step of the above-described connection structure 100L, the opening 13C is formed by laser processing, and the other steps are the same as the connection structure 100L.

According to the superconducting wire rod connection structure 100M, the area in which the oxygen is supplied due to the openings 13C becomes smaller, and the effect of oxygen annealing reduces, but the other advantageous effects can be achieved as in the connection structure 100L. Moreover, since the openings 13C can be formed by laser processing, the time necessary for forming the connection structure 100M can be drastically decreased.

### [Others]

In space 6, the base materials 1, 1 are removed in a tilted shape so as to be deeper when closer to the joining portion, but the shape is not limited to the above, and the base materials 1, 1 can be removed so that the depth is equal in the entire range of the length b.

In all of the connection structures provided with the space 6, a sealing step which fills the space 6 with resin can be provided after the oxygen annealing step or between the oxygen annealing step and the stabilizing layer forming step. Preferably, the resin hardens later. With this, the strength of all connection structures can be enhanced by the structure of the space 6 as the separating portion between the connection ends of the first and second superconducting wire rods 10A, 10B and the connection wire rods 10C, 10D, 10E or connection superconducting wire rod 15C being filled with resin as filling.

According to the superconducting wire rod connection structure 100, when the superconducting critical current density can be achieved sufficiently in the connection between layers of the superconducting conductor layers 3, 3 of the first and second superconducting wire rods 10A, 10B and the superconducting conductor layer 3C of the connection wire rod 10C, the superconducting film does not have to be formed on the inner side portion of the space 6 in the connection superconducting film 5.

According to the superconducting wire rod connection structure 100E, when the superconducting critical current density can be achieved sufficiently in the connection between layers of the superconducting conductor layers 3, 3 of the first and second superconducting wire rods 10A, 10B and the superconducting conductor layer 3C of the connection wire rod 10C, the connection superconducting film 5E does not have to be formed.

The shape of the openings 13, 13C is not limited to a rectangle. The openings 13, 13C can be formed in a circle or any other shape. For example, a honeycomb structure including hexagonal openings can make the area (square dimension) of the opening large while suppressing the reduction of strength, and is therefore preferable. The opening can also be formed in a groove shape. In this case, the opening can be formed to be wide, and the oxygen can be efficiently supplied to the superconducting conductor layers 3 or 3C.

According to the above-described examples and embodiments, the openings 13 are formed in the first and second superconducting wire rods 15A, 15B including an intermediate layer 2, but the openings 13 can be formed in the superconducting wire rod not including the intermediate layer 2. That is, the openings 13 are to be formed so as not to penetrate the superconducting conductor layer 3, and the etching liquid and the etching time can be adjusted to form the opening 13 to a depth which does not penetrate the base material 1.

In all connection structures 100J to 100M including the openings 13 or 13C, a filling step can be provided to fill the openings 13 or 13C with resin after the oxygen annealing step or between the oxygen annealing step and the stabilizing layer forming step. Preferably, the resin hardens later. With this, the forming portion of the openings 13 or 13C in which the strength tends to decrease, the resin as a filling material is filled. With this, the strength can be enhanced.

The film forming of the connection superconducting films 5, 5E and the joining of the superconducting conductor layers 3 or 3C is not limited to the MOD method. For example, the film can be formed by chemical vapor deposition method (CVD method), pulsed laser deposition method (PLD method), or metal organic chemical vapor deposition method (MOCVD method).

### Industrial Applicability

The present invention can be applied in the field which uses a superconducting wire rod for connection.

### Description of Reference Numerals

- 1, 1C, 1D: base material
- 2, 2C: intermediate layer
- 3, 3C: superconducting conductor layer
- 4, 4C, 4D: stabilizing layer
- 5, 5E: connection superconducting film
- 6: space (separating portion)
- 10, 15: superconducting wire rod
- 10A, 15A: first superconducting wire rod
- 10B, 15B: second superconducting wire rod
- 10C, 10D, 10E: connection wire rod
- 11: film forming surface
- 12, 12C: back surface
- 13, 13C: opening
- 15C: third superconducting wire rod
- 15D: reinforcing wire rod
- 51: etching resist
- 60: reinforcing material
- 61: one end
- 62: other end
- 100, 100A, 100D to 100M: connection structure

## Claims

1. A superconducting wire rod connection structure (100L) comprising:
first and second superconducting wire rods (15A, 15B), wherein,
the first and second superconducting wire rods (15A, 15B) are formed by layering a base material (1), an intermediate layer (2), and a superconducting conductor layer (3),
the base materials (1) of the first and second superconducting wire rods (15A, 15B) are joined to each other, and
the superconducting conductor layers (3) of the first and second superconducting wire rods (15A, 15B) are connected by a connection wire rod (15C) including a superconducting conductor layer (3C), and
a separating portion (6) in which connection ends of the first and second superconducting wire rods (15A, 15B) with the base materials (1) joined to each other are separated from the connection wire rod (15C)
**characterized in that**
the superconducting conductor layers (3) of the first and second superconducting wire rods (15A, 15B) and the superconducting conductor layer (3C) of the connection wire rod (15C) are joined facing each other; and
an opening (13C) is provided on a surface of the base material (1C) on a side (12C) opposite of the superconducting conductor layer (3C) within either one or both joining ranges between the first and second superconducting wire rods (15A, 15B) and the connection wire rod (15C).

2. The superconducting wire rod connection structure according to claim 1, wherein, the superconducting conductor layers (3) of the first and second superconducting wire rods (15A, 15B) are connected with the superconducting conductor layer (3C) of the connection wire rod (15C) such that a current can flow in a superconducting state.

3. The superconducting wire rod connection structure according to claim 1 or 2, wherein, a connection superconducting film (5) is formed in a portion of the connection wire rod (15C) of the separating portion (6).

4. The superconducting wire rod connection structure according to any one of claims 1 to 3, wherein
a connection superconducting film (5) connects the superconducting conductor layers (3) of the first and second superconducting wire rods (15A, 15B) to a portion of the connection wire rod (15C) of the separating portion (6).

5. The superconducting wire rod connection structure according to claim 3 or 4, wherein, the connection superconducting film (5) is formed between the superconducting conductor layer (3) of the first and second superconducting wire rods (15A, 15B) and the connection wire rod (15C).

6. The superconducting wire rod connection structure according to any one of claims 1 to 5, wherein, the separating portion (6) is formed by removing the intermediate layer (2) and the superconducting conductor layer (3) of the connection end of the first and second superconducting wire rods (15A, 15B) .

7. The superconducting wire rod connection structure according to claim 6, wherein, the separating portion (6) is formed by removing a portion of the base material (1) in addition to removing the intermediate layer (2) and the superconducting conductor layer (3) of the connection end of the first and second superconducting wire rods (15A, 15B).

8. The superconducting wire rod connection structure according to any one of claims 1 to 7 wherein:
in the superconducting wire rods (15A, 15B) an oxide superconducting conductor layer is formed on one side of a base material (1), and the oxide superconducting conductor layers of the two superconducting wire rods (15A, 15B) are joined facing each other; and
the opening (13C) is provided with a depth so as not to penetrate the oxide superconducting conductor layer (3C).

9. The connection structure of the superconducting wire rod according to claim 8, further comprising a reinforcing member (4) in which one end and another end are separately connected to the two superconducting wire rods (15A, 15B) with the opening (13C) in between at both sides in a longitudinal direction of the superconducting wire rod.

10. The connection structure of the superconducting wire rod according to claim 9, wherein, the one end and the another end of the reinforcing member (4) are each joined on an opposite side of the oxide superconducting conductor layer in the base material (1) of each of the two superconducting wire rods (15A, 15B).

11. The superconducting wire rod connection structure according to any one of claims 8 to 10, wherein,
the superconducting wire rod (15A, 15B, 15C) includes an intermediate layer (4) between the base material (1) and the oxide superconducting conductor layer (3); and
the opening (13, 13C) is formed to reach the intermediate layer (4).

12. The superconducting wire rod connection structure according to any one of claims 1 to 11, wherein, the opening (13, 13C) is formed in a groove shape.

13. The superconducting wire rod connection structure according to any one of claims 1 to 12, wherein, a plurality of openings are formed aligned.

14. A superconducting wire rod connection method of first and second superconducting wire rods (10A, 10B) in which a base material (1), an intermediate layer (2), and a superconducting conductor layer (3) are formed by layering, the method comprising:
first removing to remove the intermediate layers (2) and the superconducting conductor layers (3) of the first and second superconducting wire rods (10A, 10B);
joining by welding the base materials (1) of the first and second superconducting wire rods (10A, 10B);
attaching a connection wire rod (10C) including a superconducting conductor layer (3C) by bridging between the superconducting conductor layers (3) of the first and second superconducting wire rods (10A, 10B); and
oxygen annealing,
wherein, in the connection wire rod (10C) attaching, a separating portion (6) is formed, wherein, the separating portion (6) is formed by separating connection ends of the first and second superconducting wire rods (10A, 10B) with the base materials (1) joined with each other from the connection wire rod (10C), the method further comprising,
exposing the superconducting conductor layer (3) of the first and second superconducting wire rods (10A, 10B) before the first removing; and
forming an opening (13) on a surface on a side opposite (12) of the superconducting conductor layer (3) in the base material (1) in either one or both joining ranges of the first and second superconducting wire rods (10A, 10B) and the connection wire rod.

15. The superconducting wire rod connection method according to claim 14, further comprising film forming to form a connection superconducting film (5) in a portion of the connection wire rod (10C) of the separating portion (6).

16. The superconducting wire rod connection method according to claim 15, wherein, in the film forming, the connection superconducting film (5) is formed between the superconducting conductor layers (3) of the first and second superconducting wire rods (10A, 10B) and the connection wire rod (10C).

17. The superconducting wire rod connection method according to any one of claims 14 to 16, further comprising a second removing in which a portion of the base material of the connection end of the first and second superconducting wire rods (10A, 10B) are removed.

18. The superconducting wire rod connection method of any one of claims 14 - 17 for connecting superconducting wire rods (10A, 10B) in which an oxide superconducting conductor layer is formed on one side of a base material (1), the method further comprising:
exposing the oxide superconducting conductor layers of two superconducting wire rods (10A, 10B);
joining the oxide superconducting conductor layers of the two superconducting wire rods (10A, 10B) with the oxide superconducting conductor layers facing each other;
forming the opening (6) on a surface on a side opposite of the oxide superconducting conductor layer in the base material (1) within a joining range of one or both superconducting wire rods (10A, 10B) by etching at a depth so as not to penetrate the oxide superconducting conductor layer; and
oxygen annealing on the oxide superconducting conductor layers.

19. The superconducting wire rod connection method according to claim 18, wherein the joining further includes, positioning a precursor of the oxide superconducting conductor in one or both oxide superconducting conductor layers of the two superconducting wire rods (10A, 10B); and
baking the precursor of the oxide superconducting conductor.

20. The superconducting wire rod connection method of claim 18 or 19, wherein connection ends of the two superconducting wire rods (10A, 10B) confront each other by the connection superconducting wire rod (10C) in which an oxide superconducting conductor layer is formed on one side of a base material (1), the method comprising:
joining the oxide superconducting conductor layers of the two superconducting wire rods (10A, 10B) to the oxide superconducting conductor layer of the connection superconducting wire rod (10C) facing each other.

21. The superconducting wire rod connection method according to claim 20, wherein the joining further includes, positioning a precursor of the oxide superconducting conductor in one or both of the oxide superconducting conductor layer of the connection superconducting wire rod (10C) and the oxide superconducting conductor layers of the two superconducting wire rods (10A, 10B); and
baking the precursor of the oxide superconducting conductor.

22. A superconducting wire rod including a superconducting wire rod connected by a superconducting wire rod connection structure according to any one of claims 1 to 13.

## Patentansprüche

1. Supraleitende Stabdrahtverbindungsstruktur (100L), umfassend:
einen ersten und einen zweiten supraleitenden Stabdraht (15A, 15B), wobei
der erste und der zweite supraleitende Stabdraht (15A, 15B) durch Schichten eines Basismaterials (1), einer Zwischenschicht (2) und einer supraleitenden Leiterschicht (3) gebildet werden,
die Basismaterialien (1) des ersten und des zweiten supraleitenden Stabdrahts (15A, 15B) miteinander verbunden sind, und
die supraleitenden Leiterschichten (3) des ersten und des zweiten supraleitenden Stabdrahts (15A, 15B) durch einen Verbindungsstabdraht (15C), der eine supraleitende Leiterschicht (3C) aufweist, verbunden sind, und
einen Trennabschnitt (6), in dem die Verbindungsenden des ersten und des zweiten supraleitenden Stabdrahts (15A, 15B) mit den miteinander verbundenen Basismaterialien (1) von dem Verbindungsstabdraht (15C) getrennt sind,
**dadurch gekennzeichnet, dass**
die supraleitenden Leiterschichten (3) des ersten und des zweiten supraleitenden Stabdrahts (15A, 15B) und die supraleitende Leiterschicht (3C) des Verbindungsstabdrahts (15C) einander zugewandt verbunden sind; und
eine Öffnung (13C) auf einer Oberfläche des Basismaterials (1C) auf einer Seite (12C) gegenüber der supraleitenden Leiterschicht (3C) innerhalb entweder eines oder beider Verbindungsbereiche zwischen dem ersten und dem zweiten supraleitenden Stabdrahts (15A, 15B) und dem Verbindungsstabdraht (15C) vorgesehen ist.

2. Supraleitende Stabdrahtverbindungsstruktur gemäß Anspruch 1, wobei die supraleitenden Leiterschichten (3) des ersten und des zweiten supraleitenden Stabdrahts (15A, 15B) mit der supraleitenden Leiterschicht (3C) des Verbindungsstabdrahts (15C) so verbunden sind, dass ein Strom in einem supraleitenden Zustand fließen kann.

3. Supraleitende Stabdrahtverbindungsstruktur gemäß Anspruch 1 oder 2, wobei ein supraleitender Verbindungsfilm (5) in einem Abschnitt des Verbindungsstabdrahts (15C) des Trennabschnitts (6) gebildet ist.

4. Supraleitende Stabdrahtverbindungsstruktur gemäß einem der Ansprüche 1 bis 3, wobei
ein supraleitender Verbindungsfilm (5) die supraleitenden Leiterschichten (3) des ersten und des zweiten supraleitenden Stabdrahts (15A, 15B) mit einem Abschnitt des Verbindungsstabdrahts (15C) des Trennabschnitts (6) verbindet.

5. Supraleitende Stabdrahtverbindungsstruktur gemäß Anspruch 3 oder 4, wobei der supraleitende Verbindungsfilm (5) zwischen der supraleitenden Leiterschicht (3) des ersten und des zweiten supraleitenden Stabdrahts (15A, 15B) und dem Verbindungsstabdraht (15C) gebildet ist.

6. Supraleitende Stabdrahtverbindungsstruktur gemäß einem der Ansprüche 1 bis 5, wobei der Trennabschnitt (6) durch Entfernen der Zwischenschicht (2) und der supraleitenden Leiterschicht (3) des Verbindungsendes des ersten und des zweiten supraleitenden Stabdrahts (15A, 15B) gebildet ist.

7. Supraleitende Stabdrahtverbindungsstruktur gemäß Anspruch 6, wobei der Trennabschnitt (6) durch Entfernen eines Abschnitts des Basismaterials (1) zusätzlich zum Entfernen der Zwischenschicht (2) und der supraleitenden Leiterschicht (3) des Verbindungsendes des ersten und des zweiten supraleitenden Stabdrahts (15A, 15B) gebildet ist.

8. Supraleitende Stabdrahtverbindungsstruktur gemäß einem der Ansprüche 1 bis 7, wobei:
in den supraleitenden Walzdrähten (15A, 15B) auf einer Seite eines Basismaterials (1) eine oxidsupraleitende Leiterschicht gebildet ist und die oxidsupraleitenden Leiterschichten der beiden supraleitenden Walzdrähte (15A, 15B) einander zugewandt verbunden sind; und
die Öffnung (13C) mit einer Tiefe versehen ist, um die oxidsupraleitende Leiterschicht (3C) nicht zu durchdringen.

9. Verbindungsstruktur des supraleitenden Stabdrahts gemäß Anspruch 8, ferner umfassend ein Verstärkungselement (4), bei dem ein Ende und ein anderes Ende getrennt mit den beiden supraleitenden Walzdrähten (15A, 15B) verbunden sind, wobei die Öffnung (13C) dazwischen an beiden Seiten in Längsrichtung des supraleitenden Stabdrahts liegt.

10. Verbindungsstruktur des supraleitenden Stabdrahts gemäß Anspruch 9, wobei das eine Ende und das andere Ende des Verstärkungselements (4) jeweils auf einer gegenüberliegenden Seite der oxidsupraleitenden Leiterschicht in dem Basismaterial (1) jedes der beiden supraleitenden Walzdrähte (15A, 15B) verbunden sind.

11. Supraleitende Stabdrahtverbindungsstruktur gemäß einem der Ansprüche 8 bis 10, wobei
der supraleitende Stabdraht (15A, 15B, 15C) eine Zwischenschicht (4) zwischen dem Basismaterial und der oxidsupraleitenden Leiterschicht (3) beinhaltet; und
die Öffnung (13, 13C) so geformt ist, dass sie die Zwischenschicht erreicht.

12. Supraleitende Stabdrahtverbindungsstruktur gemäß einem der Ansprüche 1 bis 11, wobei die Öffnung (13, 13C), wobei die Öffnung in einer Nutform ausgebildet ist.

13. Supraleitende Stabdrahtverbindungsstruktur gemäß einem der Ansprüche 1 bis 12, wobei eine Mehrzahl von Öffnungen ausgerichtet ausgebildet ist.

14. Verfahren zum Verbinden von supraleitendem Stabdraht für einen ersten und einen zweiten supraleitenden Stabdraht (10A, 10B), bei dem ein Basismaterial (1), eine Zwischenschicht (2) und eine supraleitende Leiterschicht (3) durch Schichten gebildet werden, wobei das Verfahren umfasst:
erstes Entfernen zum Entfernen der Zwischenschichten (2) und der supraleitenden Leiterschichten (3) des ersten und des zweiten supraleitenden Stabdrahts (10A, 10B);
Verbinden durch Schweißen der Basismaterialien (1) des ersten und des zweiten supraleitenden Stabdrahts (10A, 10B);
Befestigen eines Verbindungsstabdrahts (10C) mit einer supraleitenden Leiterschicht (3C) durch Überbrücken zwischen den supraleitenden Leiterschichten (3) des ersten und des zweiten supraleitenden Stabdrahts (10A, 10B); und
Sauerstoffglühen,
wobei bei dem Befestigen des Verbindungsstabdrahts (10C) ein Trennabschnitt (6) gebildet wird, wobei der Trennabschnitt (6) durch Trennen der Verbindungsenden des ersten und des zweiten supraleitenden Stabdrahts (10A, 10B) mit den miteinander verbundenen Basismaterialien (1) von dem Verbindungsstabdraht (10C) gebildet wird, wobei das Verfahren ferner umfasst:
Freilegen der supraleitenden Leiterschicht (3) des ersten und des zweiten supraleitenden Stabdrahts (10A, 10B) vor dem ersten Entfernen; und
Bilden einer Öffnung (13) auf einer Oberfläche auf einer Seite (12) gegenüber der supraleitenden Leiterschicht (3) in dem Basismaterial (1) in entweder einem oder beiden Verbindungsbereichen des ersten und des zweiten supraleitenden Stabdrahts (10A, 10B) und des Verbindungsstabdrahts.

15. Verfahren zum Verbinden von supraleitendem Stabdraht gemäß Anspruch 14, ferner umfassend eine Filmbildung zur Bildung eines supraleitenden Verbindungsfilms (5) in einem Abschnitt des Verbindungsstabdrahts (10C) des Trennabschnitts (6).

16. Verfahren zum Verbinden von supraleitendem Stabdraht gemäß Anspruch 15, wobei bei der Filmbildung der supraleitende Verbindungsfilm (5) zwischen den supraleitenden Leiterschichten (3) des ersten und des zweiten supraleitenden Stabdrahts (10A, 10B) und dem Verbindungsstabdraht (10C) gebildet wird.

17. Verfahren zum Verbinden von supraleitendem Stabdraht gemäß einem der Ansprüche 14 bis 16, ferner umfassend ein zweites Entfernen, bei dem ein Abschnitt des Basismaterials des Verbindungsendes des ersten und zweiten supraleitenden Stabdrahts (10A, 10B) entfernt wird.

18. Verfahren zum Verbinden von supraleitendem Stabdraht gemäß einem der Ansprüche 14 bis 17 zum Verbinden der supraleitenden Walzdrähte (10A, 10B), bei dem eine oxidsupraleitende Leiterschicht auf einer Seite des Basismaterial (1) gebildet wird, wobei das Verfahren ferner umfasst:
Freilegen der oxidsupraleitenden Leiterschichten der beiden supraleitenden Walzdrähten (10A, 10B);
Verbinden der oxidsupraleitenden Leiterschichten der beiden supraleitenden Walzdrähte (10A, 10B) mit den oxidsupraleitenden Leiterschichten, die einander zugewandt sind;
Bilden der Öffnung (6) auf einer Oberfläche auf einer der oxidsupraleitenden Leiterschicht gegenüberliegenden Seite in dem Basismaterial (1) innerhalb eines Fügebereichs eines oder beider supraleitender Walzdrähte (10A, 10B) durch Ätzen in einer Tiefe, um die oxidsupraleitende Leiterschicht nicht zu durchdringen; und
Sauerstoffglühen auf den oxidsupraleitenden Leiterschichten.

19. Verfahren zum Verbinden von supraleitendem Stabdraht gemäß Anspruch 18, wobei das Verbinden ferner beinhaltet:
Positionieren eines Vorläufers des oxidsupraleitenden Leiters in einer oder beiden der oxidsupraleitenden Leiterschichten der beiden supraleitenden Walzdrähte (10A, 10B); und
Backen des Vorläufers des oxidsupraleitenden Leiters.

20. Verfahren zum Verbinden von supraleitendem Stabdraht gemäß Anspruch 18 oder 19, wobei die Verbindungsenden der beiden supraleitenden Walzdrähte (10A, 10B) durch den supraleitenden Verbindungsstabdraht, in dem eine oxidsupraleitende Leiterschicht auf einer Seite eines Basismaterials (1) gebildet ist, einander gegenüberliegen, wobei das Verfahren umfasst:
Verbinden der oxidsupraleitenden Leiterschichten der beiden supraleitenden Walzdrähte (10A, 10B) mit der oxidsupraleitenden Leiterschicht des supraleitenden Verbindungsstabdrahts (10C), die einander zugewandt sind.

21. Verfahren zum Verbinden von supraleitendem Stabdraht gemäß Anspruch 20, wobei das Verbinden ferner beinhaltet:
Positionieren eines Vorläufers des oxidsupraleitenden Leiters in einer oder beiden der oxidsupraleitenden Verbindungsschicht des supraleitenden Verbindungsstabdrahts (10C) und den oxidsupraleitenden Leiterschichten der beiden supraleitenden Walzdrähte (10A, 10B); und
Backen des Vorläufers des oxidsupraleitenden Leiters.

22. Supraleitender Stabdraht mit einem supraleitenden Stabdraht, der durch eine supraleitende Stabdrahtverbindungsstruktur gemäß einem der Ansprüche 1 bis 13 verbunden ist.

## Revendications

1. Structure de connexion (100L) de tiges de fil supraconducteur, comprenant :
des première et seconde tiges de fil supraconducteur (15A, 15B), dans laquelle,
les première et seconde tiges de fil supraconducteur (15A, 15B) sont formées par une stratification d'un matériau de base (1), d'une couche intermédiaire (2) et d'une couche de conducteur supraconducteur (3),
les matériaux de base (1) des première et seconde tiges de fil supraconducteur (15A, 15B) sont liés l'un à l'autre, et
les couches de conducteur supraconducteur (3) des première et seconde tiges de fil supraconducteur (15A, 15B) sont connectées par une tige de fil de connexion (15C) comprenant une couche de conducteur supraconducteur (3C), et
une partie de séparation (6) dans laquelle des extrémités de connexion des première et seconde tiges de fil supraconducteur (15A, 15B), dont les matériaux de base (1) sont liés l'un à l'autre, sont séparées de la tige de fil de connexion (15C)
**caractérisée en ce que**
les couches de conducteur supraconducteur (3) des première et seconde tiges de fil supraconducteur (15A, 15B) et la couche de conducteur supraconducteur (3C) de la tige de fil de connexion (15C) sont liées les unes aux autres d'une manière face à face ; et
une ouverture (13C) est ménagée dans une surface du matériau de base (1C) sur un côté (12C) opposé de la couche de conducteur supraconducteur (3C) sur une distance ou sur les deux distances de liaison entre les première et seconde tiges de fil supraconducteur (15A, 15B) et la tige de fil de connexion (15C).

2. Structure de connexion de tiges de fil supraconducteur selon la revendication 1, dans laquelle les couches de conducteur supraconducteur (3) des première et seconde tiges de fil supraconducteur (15A, 15B) sont connectées à la couche de conducteur supraconducteur (3C) de la tige de fil de connexion (15C) de sorte qu'un courant puisse circuler dans un état de supraconduction.

3. Structure de connexion de tiges de fil supraconducteur selon la revendication 1 ou la revendication 2, dans laquelle un film supraconducteur (5) de connexion est formé dans une partie de la tige de fil de connexion (15C) de la partie de séparation (6).

4. Structure de connexion de tiges de fil supraconducteur selon l'une quelconque des revendications 1 à 3, dans laquelle
un film supraconducteur (5) de connexion établit la connexion entre les couches de conducteur supraconducteur (3) des premières et seconde tiges de fil supraconducteur (15A, 15B) et une partie de la tige de fil de connexion (15C) de la partie de séparation (6).

5. Structure de connexion de tiges de fil supraconducteur selon la revendication 3 ou la revendication 4, dans laquelle le film supraconducteur (5) de connexion est formé entre la couche de conducteur supraconducteur (3) des première et seconde tiges de fil supraconducteur (15A, 15B) et la tige de fil de connexion (15C).

6. Structure de connexion de tiges de fil supraconducteur selon l'une quelconque des revendications 1 à 5, dans laquelle la partie de séparation (6) est formée par une élimination de la couche intermédiaire (2) et de la couche de conducteur supraconducteur (3) de l'extrémité de connexion des première et seconde tiges de fil supraconducteur (15A, 15B).

7. Structure de connexion de tiges de fil supraconducteur selon la revendication 6, dans laquelle la partie de séparation (6) est formée par une élimination d'une partie du matériau de base (1) en plus de l'élimination de la couche intermédiaire (2) et de la couche de conducteur supraconducteur (3) de l'extrémité de connexion des première et seconde tiges de fil de connexion supraconducteur (15A, 15B).

8. Structure de connexion de tiges de fil supraconducteur selon l'une quelconque des revendications 1 à 7, dans laquelle :
une couche de conducteur supraconducteur à oxyde est formée dans les tiges de fil supraconducteur (15A, 15B) sur un côté d'un matériau de base (1), et les couches de conducteur supraconducteur à oxyde des tiges de fil supraconducteur (15A, 15B) sont liées l'une à l'autre d'une manière face à face ; et
l'ouverture (13C) est ménagée sur une profondeur définie de façon à ne pas pénétrer la couche de conducteur supraconducteur à oxyde (3C).

9. Structure de connexion de la tige de fil supraconducteur selon la revendication 8, comprenant en outre un élément de renfort (4) dans lequel une extrémité et une autre extrémité sont connectées séparément aux deux tiges de fil supraconducteur (15A, 15B), l'ouverture (13C) se trouvant entre elles, des deux côtés dans une direction longitudinale de la tige de fil supraconducteur.

10. Structure de connexion de la tige de fil supraconducteur selon la revendication 9, dans laquelle la première extrémité et l'autre extrémité de l'élément de renfort (4) sont individuellement liées, sur un côté opposé de la couche de conducteur supraconducteur à oxyde, au matériau de base (1) de chacune des deux tiges de fil supraconducteur (15A, 15B).

11. Structure de connexion de tiges de fil supraconducteur selon l'une quelconque des revendications 8 à 10, dans laquelle
la tige de fil supraconducteur (15A, 15B, 15C) comprend une couche intermédiaire (4) entre le matériau de base (1) et la couche de conducteur supraconducteur à oxyde (3) ; et
l'ouverture (13, 13C) est formée de façon à atteindre la couche intermédiaire (4).

12. Structure de connexion de tiges de fil supraconducteur selon l'une quelconque des revendications 1 à 11, dans laquelle l'ouverture (13, 13C) est façonnée avec une forme de rainure.

13. Structure de connexion de tiges de fil supraconducteur selon l'une quelconque des revendications 1 à 12, dans laquelle plusieurs ouvertures sont formées alignées.

14. Procédé de connexion de tiges de fil supraconducteur de première et seconde tiges de fil supraconducteur (10A, 10B) dans lesquelles un matériau de base (1), une couche intermédiaire (2) et une couche de conducteur supraconducteur (3) sont formés par une stratification, le procédé comprenant les étapes consistant à :
pratiquer d'abord une élimination visant à éliminer les couches intermédiaires (2) et les couches de conducteur supraconducteur (3) des première et seconde tiges de fil supraconducteur (10A, 10B) ;
lier par soudage les matériaux de base (1) des première et seconde tiges de fil supraconducteur (10A, 10B) ;
apposer une tige de fil de connexion (10C) comprenant une couche de conducteur supraconducteur (3C) par un pontage entre les couches de conducteur supraconducteur (3) des première et seconde tiges de fil supraconducteur (10A, 10B) ; et
exécuter un recuit à l'oxygène,
dans lequel, lors de l'apposition de la tige de fil de connexion (10C), une partie de séparation (6) est formée, dans lequel la partie de séparation (6) est formée par une séparation d'extrémités de connexion des première et seconde tiges de fil supraconducteur (10A, 10B), les matériaux de base (1) étant liés l'un à l'autre, de la tige de fil de connexion (10C), le procédé comprenant en outre les étapes consistant à :
exposer la couche de conducteur supraconducteur (3) des première et seconde tiges de fil supraconducteur (10A, 10B) avant la première élimination ; et
ménager une ouverture (13) dans une surface sur un côté opposé (12) de la couche de conducteur supraconducteur (3) du matériau de base (1) sur une distance ou sur les deux distances de liaison des première et seconde tiges de fil supraconducteur (10A, 10B) et de la tige de fil de connexion.

15. Procédé de connexion de tiges de fil supraconducteur selon la revendication 14, comprenant en outre une étape de formation de film consistant à former un film supraconducteur (5) de connexion dans une partie de la tige de fil de connexion (10C) de la partie de séparation (6).

16. Procédé de connexion de tiges de fil supraconducteur selon la revendication 15, dans lequel, à l'étape de formation de film, le film supraconducteur (5) de connexion est formé entre les couches de conducteur supraconducteur (3) des première et seconde tiges de fil supraconducteur (10A, 10B) et de la tige de fil de connexion (10C).

17. Procédé de connexion de tiges de fil supraconducteur selon l'une quelconque des revendications 14 à 16, comprenant en outre une étape de seconde élimination durant laquelle une partie du matériau de base de l'extrémité de connexion des première et seconde tiges de fil supraconducteur (10A, 10B) est éliminée.

18. Procédé de connexion de tiges de fil supraconducteur selon l'une quelconque des revendications 14 à 17 permettant de connecter des tiges de fil supraconducteur (10A, 10B) dans lesquelles une couche de conducteur supraconducteur à oxyde est formée sur un côté d'un matériau de base (1), le procédé comprenant en outre les étapes consistant à :
exposer les couches de conducteur supraconducteur à oxyde des deux tiges de fil supraconducteur (10A, 10B) ;
lier les couches de conducteur supraconducteur à oxyde des deux tiges de fil supraconducteur (10A, 10B), les couches de conducteur supraconducteur à oxyde se faisant face ;
ménager l'ouverture (6) dans une surface, sur un côté opposé de la couche de conducteur supraconducteur à oxyde, du matériau de base (1) sur une distance de liaison de l'une ou des deux tiges de fil supraconducteur (10A, 10B) par une gravure sur une profondeur définie de façon à ne pas pénétrer la couche de conducteur supraconducteur à oxyde ; et
exécuter un recuit à l'oxygène des couches de conducteur supraconducteur à oxyde.

19. Procédé de connexion de tiges de fil supraconducteur selon la revendication 18, dans lequel l'étape de liaison consistant en outre à
placer un précurseur du conducteur supraconducteur à oxyde dans une couche ou dans les deux couches des couches de conducteur supraconducteur à oxyde des deux tiges de fil supraconducteur (10A, 10B) ; et
cuire le précurseur du conducteur supraconducteur à oxyde.

20. Procédé de connexion de tiges de fil supraconducteur selon la revendication 18 ou la revendication 19, dans lequel des extrémités de connexion des deux tiges de fil supraconducteur (10A, 10B) sont confrontées l'une à l'autre par la tige de fil supraconducteur de connexion (10C), dans lesquelles une couche de conducteur supraconducteur à oxyde est formée sur un côté d'un matériau de base (1), le procédé comprenant l'étape consistant à :
lier les couches de conducteur supraconducteur à oxyde des deux tiges de fil supraconducteur (10A, 10B) à la couche de conducteur supraconducteur à oxyde de la tige de fil supraconducteur de connexion (10C) d'une manière face à face.

21. Procédé de connexion de tiges de fil supraconducteur selon la revendication 20, dans lequel l'étape de liaison consiste en outre à
placer un précurseur du conducteur supraconducteur à oxyde dans une couche ou dans les deux couches de la couche de conducteur supraconducteur à oxyde de la tige de fil supraconducteur de connexion (10C) et des couches de conducteur supraconducteur à oxyde des deux tiges de fil supraconducteur (10A, 10B) ; et
cuire le précurseur du conducteur supraconducteur à oxyde.

22. Tige de fil supraconducteur comprenant une tige de fil supraconducteur connectée par une structure de connexion de tiges de fil supraconducteur selon l'une quelconque des revendications 1 à 13.
